# EUROPEAN PATENT APPLICATION

(11) **EP 4 672 926 A1**
(43) Date of publication of application: **31.12.2025**
(21) Application number: 25184771.1
(22) Date of filing: 24.06.2025
(51) Int. Cl.: H10H 29/14, H04B 10/80, H10F 55/25, H10H 29/24

(54) **OPTICAL INTERCONNECT SYSTEM**

(30) Priority: 28.06.2024 KR 20240085507; 19.12.2024 KR 20240191726
(71) Applicant: SAMSUNG ELECTRONICS CO., LTD., Yeongtong-gu Suwon-si, Gyeonggi-do 16677 (KR)
(72) Inventor: KIM, Sunwoon, 16677 Suwon-si, Gyeonggi-do (KR); INOUE, Shigeru, 16677 Suwon-si, Gyeonggi-do (KR); CHOI, Youngjin, 16677 Suwon-si, Gyeonggi-do (KR)
(74) Representative: Kuhnen & Wacker Patent- und Rechtsanwaltsbüro PartG mbB

(57) **Abstract**

An optical interconnect system (1) includes a micro light-emitting diode, LED, array (10) including at least one micro LED, a photodiode array (20) on a side of the micro LED array (10) and including at least one photodiode, an optical transmission medium (40) coupled with the micro LED array (10) and the photodiode array (20), and a circuit board (IC) apart from the optical transmission medium in a vertical direction (Z) with the micro LED array (10) and the photodiode array (20) therebetween. The at least one micro LED includes a plurality of layers sequentially stacked in the vertical direction (Z).

## Description

### BACKGROUND

The present disclosure relates generally to an optical interconnect system, and more particularly, to an optical interconnect system that generates an optical signal by using a micro light-emitting diode (LED).

Light-emitting diodes (LEDs) may refer to light sources that may convert an electrical energy into an optical energy, and may be widely used as light sources for various display devices, such as, but not limited to, lighting devices, televisions (TVs), mobile phones, personal computers (PCs), laptops, personal digital assistants (PDAs), digital cameras, camcorders, viewfinders, microdisplays, three-dimensional (3D) displays, virtual reality and/or augmented reality displays, or the like. Recently, micro- and/or nano-sized ultra-small LEDs that may use Group II-VI and/or Group III-V compound semiconductors may have been developed. Thus, there exists a need to develop a light-emitting device having a new structure to potentially improve the light extraction efficiency of such ultra-small LEDs.

### SUMMARY

One or more example embodiments of the present disclosure provide an optical interconnect system having improved reliability, when compared to related optical interconnect systems.

Example embodiments of the present disclosure may not be limited to those mentioned above, and other example embodiments may be understood by those skilled in the art from the following descriptions and/or may be learned by practice of the presented embodiments.

According to an aspect of the present disclosure, an optical interconnect system includes a micro light-emitting diode (LED) array including at least one micro LED, a photodiode array on a side of the micro LED array and including at least one photodiode, an optical transmission medium coupled with the micro LED array and the photodiode array, and a circuit board apart from the optical transmission medium in a vertical direction with the micro LED array and the photodiode array therebetween. The at least one micro LED includes a plurality of layers sequentially stacked in the vertical direction.

According to an aspect of the present disclosure, an optical interconnect system includes a micro LED array including a plurality of micro LEDs, a photodiode array adjacent to the micro LED array and including a plurality of photodiodes, an optical transmission medium coupled with the micro LED array and the photodiode array and including an optical fiber, and a circuit board apart from the optical transmission medium in a vertical direction with the micro LED array and the photodiode array therebetween. Each of the plurality of micro LEDs includes a plurality of layers sequentially stacked in the vertical direction. The plurality of layers includes a first conductive base semiconductor layer, a semiconductor light-emitting structure, an electrode layer, and a passivation layer. The semiconductor light-emitting structure includes first conductive semiconductor layers, an active layer, and a second conductive semiconductor layer that are sequentially stacked on a main surface of the first conductive base semiconductor layer in the vertical direction perpendicular to the main surface of the first conductive base semiconductor layer. The electrode layer at least partially covers the second conductive semiconductor layer and is apart from the active layer in the vertical direction with the second conductive semiconductor layer therebetween. The passivation layer at least partially covers a sidewall of each of the first conductive semiconductor layers, the active layer, and the second conductive semiconductor layer included in the semiconductor light-emitting structure.

According to an aspect of the present disclosure, an optical interconnect system includes a micro LED array including a plurality of micro LEDs, a photodiode array adjacent to the micro LED array and including a plurality of photodiodes, an optical transmission medium coupled with each of the micro LED array and the photodiode array and including an optical fiber, and a circuit board apart from the optical transmission medium in a vertical direction with the micro LED array and the photodiode array therebetween. Each of the plurality of micro LEDs includes a plurality of layers sequentially stacked in the vertical direction. The plurality of layers includes a first conductive base semiconductor layer, a semiconductor light-emitting structure, a transparent electrode layer, a passivation layer, a reflective structure, a first electrode layer, a second electrode layer, an insulating layer, and a microlens. The semiconductor light-emitting structure includes a first conductive semiconductor layer, an active layer, and a second conductive semiconductor layer that are sequentially stacked on a main surface of the first conductive base semiconductor layer in the vertical direction perpendicular to the main surface of the first conductive base semiconductor layer. The transparent electrode layer is in contact with the second conductive semiconductor layer. The passivation layer at least partially covers a sidewall of each of the first conductive semiconductor layer, the active layer, and the second conductive semiconductor layer included in the semiconductor light-emitting structure. The reflective structure at least partially covers a sidewall of the passivation layer. The first electrode layer at least partially covers a sidewall of the reflective structure. A second electrode layer is adjacent to the semiconductor light-emitting structure. The insulating layer at least partially covers the semiconductor light-emitting structure and forming a spacer. The microlens is in contact with an emission surface of the first conductive base semiconductor layer and is configured to extract light emitted from the semiconductor light-emitting structure. The emission surface of the first conductive base semiconductor layer includes a portion of a back surface thereof opposite to the main surface thereof.

According to an aspect of the present disclosure, a method of manufacturing an optical interconnect system including a micro LED array includes forming, on a growth substrate, a first conductive base semiconductor layer, forming, on the first conductive base semiconductor layer, a plurality of semiconductor light-emitting structures in a pixel region, each structure of the plurality of semiconductor light-emitting structures including a first conductive semiconductor layer, an active layer, and a second conductive semiconductor layer, forming a plurality of transparent electrode layers at least partially covering the plurality of semiconductor light-emitting structures, forming sequentially and conformally, in a vertical direction, a passivation layer, a reflective structure, and a first electrode layer on an outer wall of each structure of the plurality of semiconductor light-emitting structures, forming an insulating layer to at least partially cover an outer wall of the first electrode layer, the insulating layer having a constant upper surface height, exposing at least one portion of the first conductive base semiconductor layer by etching back at least one portion of the insulating layer, the first electrode layer, the reflective structure, and the passivation layer, forming a second electrode layer in the at least one portion of the first conductive base semiconductor layer exposed by the etching, forming a plurality of through vias coupled with the plurality of semiconductor light-emitting structures and the second electrode layer, forming a second bonding insulating layer at least partially covering the plurality of through vias and the insulating layer in the pixel region, forming a plurality of second bonding electrodes corresponding to the plurality of through vias, and bonding a plurality of first bonding electrodes of a circuit board to the plurality of second bonding electrodes.

The forming of the plurality of semiconductor light-emitting structures may include etching at least one portion of each of the plurality of transparent electrode layers, the second conductive semiconductor layer, the active layer, and the first conductive semiconductor layer.

The etching of the at least one portion of each of the plurality of transparent electrode layers, the second conductive semiconductor layer, the active layer, and the first conductive semiconductor layer may include removing regions damaged by the etching using a wet etching process.

The forming of the plurality of semiconductor light-emitting structures may include forming the plurality of semiconductor light-emitting structures to have at least one of a circular, oval, or polygonal planar shape.

The forming of the plurality of semiconductor light-emitting structures may include forming the plurality of semiconductor light-emitting structures using at least one of a metal organic chemical vapor deposition (MOCVD), a hydride vapor phase epitaxy (HVPE), or molecular beam epitaxy (MBE) process.

In the method of manufacturing the optical interconnect system, a thickness of the passivation layer, a thickness of the reflective structure, and a thickness of the first electrode layer may be equal to each other.

In the method of manufacturing the optical interconnect system, a thickness of the passivation layer, a thickness of the reflective structure, and a thickness of the first electrode layer may be different from each other.

In the method of manufacturing the optical interconnect system, a width in a horizontal direction of an edged portion of the first electrode layer may correspond to a width in the horizontal direction of an edged portion of the insulating layer. A width in the horizontal direction of an edged portion of the reflective structure and an edged portion of the passivation layer may be narrower than the width of the edged portion of the first electrode layer.

### BRIEF DESCRIPTION OF DRAWINGS

The above and other aspects, features, and advantages of certain embodiments of the present disclosure may be more apparent from the following description taken in conjunction with the accompanying drawings, in which:
FIG. 1 is a cross-sectional view of a schematic structure of an optical interconnect system, according to an embodiment;
FIG. 2 is a cross-sectional view of a schematic structure of a micro light-emitting diode (LED) array, according to an embodiment;
FIG. 3 is an enlarged view of region A in FIG. 2, according to an embodiment;
FIG. 4 is a cross-sectional view of a schematic structure of a micro LED array, according to an embodiment;
FIG. 5 is a cross-sectional view of a schematic structure of a micro LED array, according to an embodiment;
FIG. 6 is an enlarged view of region B in FIG. 5, according to an embodiment;
FIG. 7 is a cross-sectional view of a schematic structure of a micro LED array, according to an embodiment;
FIGS. 8 to 11 are each a plan view of a schematic planar shape of a semiconductor light-emitting structure, according to an embodiment;
FIG. 12A is a schematic cross-sectional view of a region of an optical interconnect system, according to an embodiment;
FIG. 12B is a schematic cross-sectional view of a region of an optical interconnect system, according to an embodiment;
FIGS. 13 to 25 are cross-sectional views illustrating a process sequence of a method of manufacturing an optical interconnect system including a micro LED array, according to an embodiment; and
FIG. 26 is a block diagram of an optical interconnect system including a photodiode, according to an embodiment.

### DETAILED DESCRIPTION

Embodiments set forth in the present disclosure may have various modifications and various forms, and thus, some embodiments may be illustrated in the drawings and described in detail. However, the present disclosure is not intended to limit the presented embodiments to specific disclosed forms. Also, the embodiments described below are merely illustrative, and various modifications may be made from these embodiments.

The use of all examples or illustrative terms is merely for describing the present disclosure in detail, and thus, the scope of the present disclosure is not limited by these examples or illustrative terms unless limited by the claims.

The following description with reference to the accompanying drawings is provided to assist in a comprehensive understanding of embodiments of the present disclosure defined by the claims and their equivalents. Various specific details are included to assist in understanding, but these details are considered to be exemplary only. Therefore, those of ordinary skill in the art may recognize that various changes and modifications of the embodiments described herein may be made. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", or the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", or the like may be used to distinguish components from each other and do not limit the present disclosure. For example, the terms "first", "second", "third", or the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the present disclosure is not limited thereto and may be realized in various other forms.

Hereinafter, unless otherwise specified, a vertical direction as used herein may be defined as a Z direction, and a first horizontal direction and a second horizontal direction as used herein may each be defined as a horizontal direction that is perpendicular to the Z direction. The first horizontal direction may be referred to as an X direction, and the second horizontal direction may be referred to as a Y direction. A vertical level may refer to a height level in the vertical direction (Z direction). A horizontal width in the first horizontal direction may refer to a length in the horizontal direction (X direction and/or Y direction), and a vertical length may refer to a length in the vertical direction (Z direction).

As used herein, each of the terms "AlGaN", "AlInGaAs", "AlInGaP", "AlN", "Al₂O₃", "CaF₂", "GaAs", "GaN", "GaO₂", "GaP", "HfO₂", "InₓAl_{y}Ga_{1-x-y}N", "InAs", "InGaN", "InP", "In₄Sn₃O₁₂", "LiAlO₂", "LiGaO₂", "MgAl₂O₄", "MgF₂", "MgO", "NbO₂", "SiC", "SICN", "Si₃N₄", "SiO₂", "SiOC", "SiOCN", "SiON", "TaN", "TaO₂", "TiAlN", "TiN", "TiO₂", "TiSiN", "Zn₍₁₋ₓ₎MgₓO", "ZnO₂", "ZrO₂", or the like may refer to a material made of elements included in each of the terms and is not a chemical formula representing a stoichiometric relationship.

Hereinafter, various embodiments of the present disclosure are described with reference to the accompanying drawings.

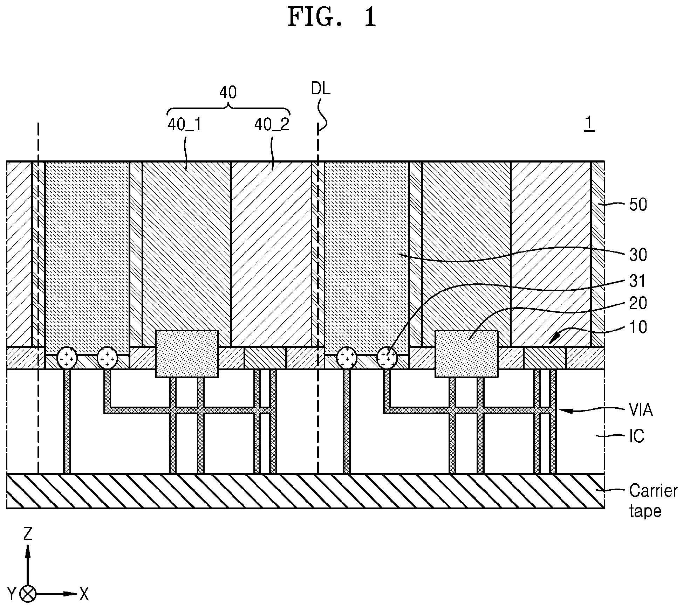

FIG. 1 is a cross-sectional view of a schematic structure of an optical interconnect system, according to an embodiment.

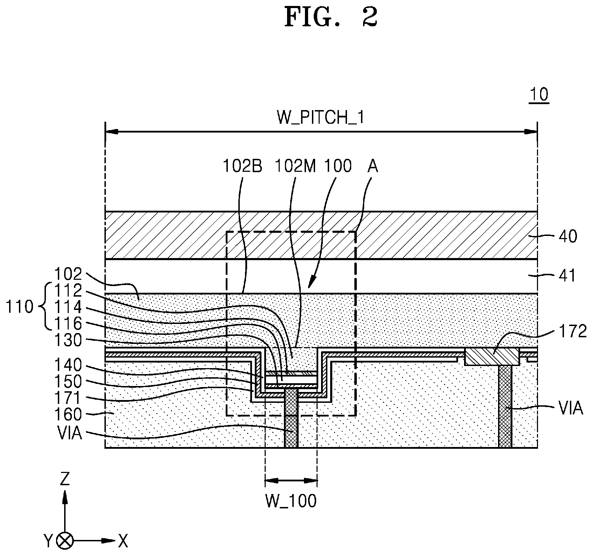

Referring to FIG. 1, an optical interconnect system 1 may include a micro light-emitting diode (LED) array 10. The micro LED array 10 may include at least one micro LED (e.g., micro LED 100 of FIG. 2). The micro LED 100 may be referred to as a light-emitting device hereinafter. The optical interconnect system 1 may include a plurality of micro LED arrays 10.

The optical interconnect system 1 may include a photodiode array 20 arranged on one side of the micro LED array 10 and an optical transmission medium 40 optically connected to each of the micro LED array 10 and the photodiode array 20. The photodiode array 20 and the micro LED array 10 may be arranged at two (2) ends of the optical transmission medium 40. The optical transmission medium 40 may have an optical fiber having a core. The optical fiber may have a single core or a multi-core. The photodiode array 20 may include at least one photodiode. The photodiode may receive an optical signal from the optical transmission medium 40 and may convert the received optical signal into an electrical signal.

In an embodiment, the optical transmission medium 40 may correspond to a waveguide. For example, an optical signal may be transmitted along the optical transmission medium 40. The optical transmission medium 40 may include a first optical transmission medium 40_1 arranged on an upper surface of the photodiode array 20 and a second optical transmission medium 40_2 arranged on an upper surface of the micro LED array 10. The first optical transmission medium 40_1 and the second optical transmission medium 40_2 may be formed as individual components separated from each other. In an embodiment, the first optical transmission medium 40_1 may be configured to transmit an optical signal to the photodiode array 20. In an embodiment, the second optical transmission medium 40_2 may receive an optical signal from the micro LED array 10.

The micro LED array 10 may include a plurality of layers sequentially stacked in a vertical direction. The plurality of layers included in the micro LED array 10 may include a semiconductor layer and/or a metal layer.

An oxide insulating layer may be arranged between the micro LED array 10 and the photodiode array 20. A separation layer 50 may be arranged at two (2) sides of the optical transmission medium 40 to distinguish the optical transmission medium 40 from another optical transmission medium 40, and a dicing line DL may be formed on at least a portion of the separation layer 50. As shown in FIG. 1, the dicing line DL of the present disclosure may correspond to a cutting reference line for separating a plurality of chiplets 30 assembled on an upper surface of a circuit board integrated circuit (IC) into individual pieces. Referring to FIG. 1, a unit to be diced may include the micro LED array 10, the photodiode array 20, and the optical transmission medium 40. The chiplet 30, as shown in FIG. 1, may be configured to perform signal conversion to meet communication standards of different devices. However, when devices have the same communication standards and or the circuit board IC arranged at a lower end of the chiplet 30 constitutes a circuit for signal conversion, the chiplet 30 may be excluded from components of the optical interconnect system 1.

The optical interconnect system 1 may include a plurality of bumpers 31 arranged at the lower end of the chiplet 30. Although, for ease of description, FIG. 1 depicts two (2) bumpers 31 as being arranged at the lower end of the chiplet 30, embodiments of the present disclosure are not limited thereto, and, for example, the number of bumpers 31 may be greater than two (2) (e.g., > 2).

The separation layer 50 may be arranged at two (2) sides of the bumper 31, and the separation layer 50 arranged at the two (2) sides of the bumper 31 may correspond to the separation layer 50 arranged at the two (2) sides of the optical transmission medium 40. The separation layer 50 may include an insulating material. The insulating material of the separation layer may include, but not be limited to, at least one of silicon oxide (SiO₂), silicon oxynitride (SiON), titanium oxide (TiO₂), silicon nitride (Si₃N₄), aluminum oxide (Al₂O₃), titanium nitride (TiN), aluminum nitride (AlN), zirconium oxide (ZrO₂), titanium aluminum nitride (TiAlN), titanium silicon nitride (TiSiN), hafnium oxide (HfO₂), niobium oxide (NbO₂), tantalum oxide (TaO₂), magnesium fluoride (MgF₂), or combinations thereof.

The optical interconnect system 1 may include a circuit board IC that may be apart from the optical transmission medium 40 in the vertical direction with the micro LED array 10 and the photodiode array 20 therebetween. A via VIA may be arranged in the circuit board IC, and the via VIA may include a metal material to transmit an electrical signal. In an embodiment, the via VIA may include, but not be limited to, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof.

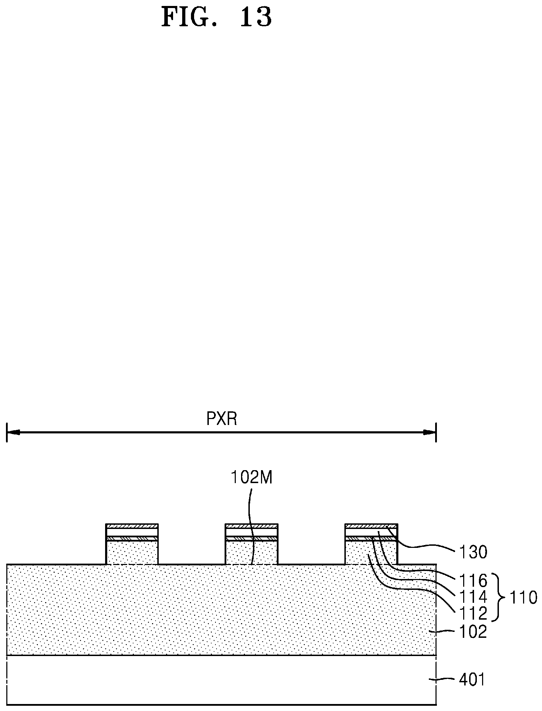

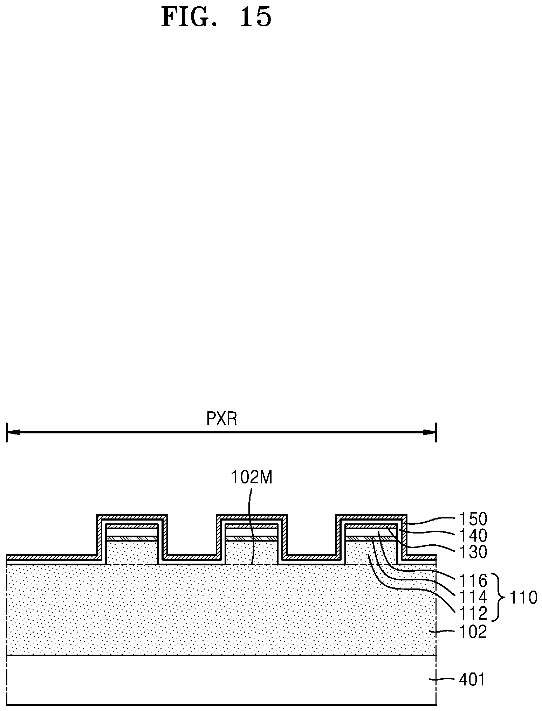

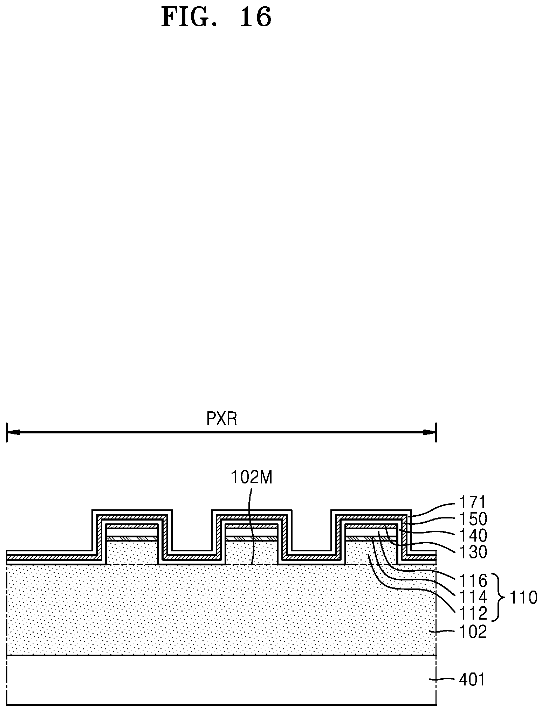

The micro LED array 10, the photodiode array 20, and the bumper 31 arranged at the lower end of the chiplet 30 may be electrically connected to each other by the circuit board IC. Although a carrier tape that may be needed during a process may be arranged at a lower end of the circuit board IC in FIG. 1, as described with reference to FIGS. 13 to 24, the carrier tape may merely be a component to be removed during the process, and thereby may not constitute a part of the optical interconnect system 1. Therefore, it may be seen that the dicing line DL may not pass through the component to be removed as described above.

The circuit board IC may be a semiconductor wafer, and may include crystalline silicon. In some embodiments, the circuit board IC may include a semiconductor element, such as, but not limited to, germanium (Ge), and/or a compound semiconductor, such as, but not limited to, silicon carbide (SiC), gallium arsenide (GaAs), indium arsenide (InAs), and indium phosphide (InP). In some embodiments, the circuit board IC may be crystalline, for example, crystalline or polycrystalline, or amorphous. In some embodiments, the circuit board IC may include a conductive region, for example, an impurity-doped well or an impurity-doped structure. In some embodiments, the circuit board IC may have various device isolation structures, such as, but not limited to, a shallow trench isolation (STI) structure. In addition, the circuit board IC may have a silicon-on-insulator (SOI) structure. The circuit board IC may include a buried oxide (BOX) layer in which a trench formed in a bulk silicon substrate may be filled with oxide.

In some embodiments, a plurality of individual devices of various types may be formed on the circuit board IC. The plurality of individual devices may include various microelectronic devices, such as, but not limited to, a metal-oxide-semiconductor field effect transistor (MOSFET), a system large scale integration (LSI), an image sensor such as, but not limited to, a complementary metal-oxide-semiconductor (CMOS) imaging sensor (CIS), a micro-electro-mechanical system (MEMS), an active device, a passive device, or the like.

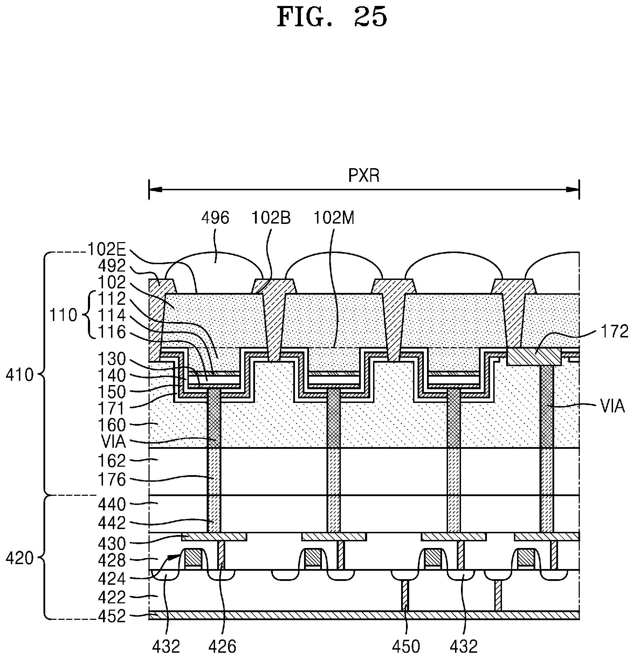

Each of the micro LED array 10 and the photodiode array 20 may be bonded to the circuit board IC by hybrid bonding, as described with reference to FIG. 25.

Micro LEDs included in the micro LED array 10 and photodiodes included in the photodiode array 20 may be coupled and connected to each other on a one-to-one basis. The photodiodes and the micro LEDs may be connected to each other through the vias VIA included in the circuit board IC. As shown in FIG. 1, two (2) vias VIA may be arranged at a lower end of the photodiode array 20. Similarly, two (2) vias VIA may be arranged at a lower end of the micro LED array 10. In an embodiment, two (2) micro LEDs may be arranged in the micro LED array 10, and two (2) photodiodes may be arranged in the photodiode array 20. The vias VIA may be arranged in a number corresponding to the respective numbers of micro LEDs and photodiodes. The vias VIA arranged in the circuit board IC may respectively correspond the micro LEDs or the photodiodes.

When the optical transmission medium 40 has a single core, the micro LEDs included in the micro LED array 10 may be coupled to the optical transmission medium 40 on a one-to-one basis. That is, one micro LED may be coupled to one core of the optical fiber included in the optical transmission medium 40. In addition, the photodiodes included in the photodiode array 20 may be coupled to one optical transmission medium 40 on a one-to-one basis.

When the optical transmission medium 40 has a multi-core, at least two (2) micro LEDs may be coupled and connected to one optical transmission medium 40. That is, the core of the optical fiber included in the optical transmission medium 40 may be a multi-core, and a plurality of micro LEDs may be included in the micro LED array 10 in correspondence to one optical fiber. When a plurality of micro LEDs correspond to one optical transmission medium 40, even when one of the micro LEDs does not operate, optical signals may be transmitted by the other micro LEDs, and thus, higher efficiency and/or reliability may be achieved against potential defects, and the total amount of light emitted by the micro LEDs may increase, thereby increasing the intensity of a signal. In addition, at least two (2) micro LEDs may be coupled and connected to one photodiode included in the photodiode array 20.

The width of the optical transmission medium 40 in a horizontal direction may be about two (2) to about ten (10) times the width of each micro LED in the horizontal direction, as described with reference to FIGS. 2 to 7. The width of the optical transmission medium 40 in the horizontal direction may be greater than two (2), three (3), four (4) or (5) times the width of each micro LED in the horizontal direction. The width of the optical transmission medium 40 in the horizontal direction may be smaller than six (6), seven (7), eight (8), nine (9) or ten (10) times the width of each micro LED in the horizontal direction.

FIG. 2 is a cross-sectional view of a schematic structure of a micro LED array, according to an embodiment.

FIG. 2 may be described with reference to FIG. 1. The micro LED array 10 shown in FIG. 2 may include one micro LED 100. The micro LED 100 may be referred to as a light-emitting device 100.

A plurality of semiconductor layers included in the light-emitting device 100 may include a first conductive base semiconductor layer 102 and a semiconductor light-emitting structure 110 arranged on a main surface 102M of the first conductive base semiconductor layer 102. The semiconductor light-emitting structure 110 may include a first conductive semiconductor layer 112, an active layer 114, and a second conductive semiconductor layer 116 that may be sequentially stacked on the main surface 102M of the first conductive base semiconductor layer 102 in a vertical direction (Z direction in FIG. 1) perpendicular to the main surface 102M of the first conductive base semiconductor layer 102.

The semiconductor light-emitting structure 110 may include a micro LED 100. In some embodiments, the semiconductor light-emitting structure 110 may include a micro LED 100 that may emit light of one color (e.g., red (R), green (G), blue (B), or the like). As used herein, the term micro LED may refer to an LED having a width of about 100 micrometers (µm) or less, for example, in a horizontal direction (e.g., X direction in FIG. 1) perpendicular to the vertical direction (Z direction in FIG. 1). However, embodiments of the present disclosure are not limited thereto, and the width of the semiconductor light-emitting structure 110 in the horizontal direction (e.g., X direction in FIG. 1) may be about 100 µm or less, about 50 µm or less, about 20 µm or less, about 10 µm or less, about 6 µm or less, about 5 µm or less, about 4 µm or less, or about 2 µm or less.

The semiconductor light-emitting structure 110 may be configured to emit light of a wavelength λ that may have a range of about 400 nanometers (nm) to about 700 nm, for example. However, embodiments of the present disclosure are not limited thereto, and the semiconductor light-emitting structure 110 may emit light (e.g., radiation) at other wavelength ranges (e.g., ultraviolet light, infrared light, or the like).

In some embodiments, the semiconductor light-emitting structure 110 may be configured to emit light of a first wavelength *λ*₁ having a range of about 580 nm to about 700 nm. For example, the light of the first wavelength *λ*₁ may be a red light. Herein, a wavelength range of red light may refer to a wavelength range of at least about 580 nm but less than about 700 nm. For example, the red light may have a wavelength range of about 610 nm to about 650 nm, or a wavelength range of about 620 nm to about 640 nm. The light of the first wavelength *λ*₁ may have at least one peak of an emission spectrum in the above discussed wavelength range of red light.

In some embodiments, the semiconductor light-emitting structure 110 may be configured to emit light of a second wavelength *λ*₂ having a range of about 490 nm to about 580 nm. For example, the light of the second wavelength λ₂ may be a green light. Herein, a wavelength range of green light may refer to a wavelength range of at least about 490 nm but less than about 580 nm. For example, the green light may have a wavelength range of about 510 nm to about 550 nm, or a wavelength range of about 520 nm to about 540 nm. The light of the second wavelength *λ*₂ may have at least one peak of an emission spectrum in the above discussed wavelength range of green light.

In some embodiments, the semiconductor light-emitting structure 110 may be configured to emit light of a third wavelength λ₃ having a range of about 400 nm to about 490 nm. For example, the light of the third wavelength λ₃ may be a blue light. Herein, a wavelength range of blue light may refer to a wavelength range of at least about 400 nm but less than about 490 nm. For example, the blue light may have a wavelength range of about 440 nm to about 480 nm, or a wavelength range of about 450 nm to about 470 nm. The light of the third wavelength *λ*₃ may have at least one peak of an emission spectrum in the above wavelength range of blue light.

The first conductive base semiconductor layer 102, the first conductive semiconductor layer 112, the active layer 114, and the second conductive semiconductor layer 116 may each include an epitaxial nitride semiconductor layer. The first conductive base semiconductor layer 102 and the first conductive semiconductor layer 112 may each include a nitride semiconductor layer doped with a dopant of the same conductive type (e.g., an n-type dopant), and the average doping concentration of the first conductive base semiconductor layer 102 may be greater than the average doping concentration of the first conductive semiconductor layer 112. The first conductive semiconductor layer 112 and the second conductive semiconductor layer 116 may each include a single layer, or may each include a multi-layer including a plurality of layers having different doping concentrations of dopants, different compositions of constituents, or the like. The first conductive base semiconductor layer 102 may be apart from the active layer 114 in the vertical direction (Z direction in FIG. 1) with the first conductive semiconductor layer 112 therebetween.

The first conductive base semiconductor layer 102 may have a thickness of about 10 nm to about 6,000 nm in the vertical direction (Z direction in FIG. 1). The first conductive semiconductor layer 112 may have a thickness of about 10 nm to about 500 nm in the vertical direction. However, the present disclosure is not limited thereto, and the first conductive base semiconductor layer 102 and the first conductive semiconductor layer 112 may have other thicknesses.

In the semiconductor light-emitting structure 110, the first conductive semiconductor layer 112 may have a structure integrally connected to the first conductive base semiconductor layer 102. In some embodiments, the first conductive base semiconductor layer 102 and the first conductive semiconductor layer 112 may include the same material. In some embodiments, the first conductive base semiconductor layer 102 may include n-type gallium nitride (n-GaN). The first conductive semiconductor layer 112 may include an n-type superlattice structure layer. For example, the first conductive semiconductor layer 112 may include an indium gallium nitride/gallium nitride (InGaN/GaN) superlattice structure layer. In this case, the first conductive semiconductor layer 112 may have a superlattice structure in which indium gallium nitride (InGaN) films and gallium nitride (GaN films) may be alternately stacked one by one. In the first conductive semiconductor layer 112, the superlattice structure may include a pair structure of an indium gallium nitride (InGaN) film and a gallium nitride (GaN) film of about ten (10) to about fifty (50) periods, for example, about 10 or 15 to about 20, 25 or 30 periods. However, embodiments of the present disclosure are not limited thereto.

In some embodiments, the first conductive semiconductor layer 112 may include a nitride semiconductor layer having a composition of indium aluminum gallium nitride (InₓAl_{y}Ga_{1-x-y}N, where 0 ≤ x < 1, 0 ≤ y < 1, 0 ≤ x + y < 1). In some embodiments, the first conductive semiconductor layer 112 may include n-type gallium nitride (n-GaN) that may be doped with silicon (Si), germanium (Ge), or carbon (C). In some embodiments, the first conductive semiconductor layer 112 may be include a semiconductor layer of aluminum indium gallium phosphide (AlInGaP) or aluminum indium gallium arsenide (AlInGaAs).

In the semiconductor light-emitting structure 110, the active layer 114 may be configured to emit light having a predetermined energy by recombination of electrons and holes. The active layer 114 may have a single quantum well or a multi-quantum well structure in which quantum barrier layers and quantum well layers may be alternately arranged.

In some embodiments, the active layer 114 may include a quantum barrier layer and a quantum well layer, each including a compound semiconductor of Group III-V elements. For example, the active layer 114 may include one pair structure of at least one of indium gallium nitride/gallium nitride (InGaN/GaN), indium gallium nitride/indium gallium nitride (InGaN/InGaN), indium gallium nitride/aluminum gallium nitride (InGaN/AlGaN), and indium gallium nitride/indium aluminum gallium nitride (InGaN/InAlGaN). However, embodiments of the present disclosure are not limited thereto.

In the vertical direction (Z direction in FIG. 1), the active layer 114 may have a thickness of less than about 300 nm. As shown in FIG. 1, the active layer 114 may have a surface in contact with the first conductive semiconductor layer 112 and a surface in contact with the second conductive semiconductor layer 116, wherein, in the active layer 114, the shortest distance from the surface in contact with the first conductive semiconductor layer 112 to the surface in contact with the second conductive semiconductor layer 116 may be less than about 300 nm.

In some embodiments, the active layer 114 may have a thickness of less than about 300 nm, less than about 200 nm, less than about 100 nm, less than about 50 nm, less than about 40 nm, less than about 20 nm, less than about 10 nm, less than about 5 nm, or less than about 3 nm. For example, the thickness of the active layer 114 may be selected from a range of about 2 nm to about 10 nm. However, embodiments of the present disclosure are not limited thereto.

An electrode layer may include a transparent electrode layer 130 covering the second conductive semiconductor layer 116, and a first electrode layer 171. The transparent electrode layer 130 may be in contact with the second conductive semiconductor layer 116, and may be apart from the active layer 114 in the vertical direction (Z direction in FIG. 1) with the second conductive semiconductor layer 116 therebetween.

The light-emitting device 100 may include a passivation layer 140 covering respective sidewalls of the first conductive semiconductor layer 112, the active layer 114, and the second conductive semiconductor layer 116 included in the semiconductor light-emitting structure 110.

The passivation layer 140 may include a silicon oxide (SiO₂) film, a silicon nitride (Si₃N₄) film, or a combination thereof. However, embodiments of the present disclosure are not limited thereto. Various deposition processes, such as, but not limited to, chemical vapor deposition (CVD), physical vapor deposition (PVD), or the like may be used to form the passivation layer 140. For example, the passivation layer 140 formed through such processes may be formed conformally.

A micro LED as the light-emitting device 100 may further include a reflective structure 150 covering a sidewall of the passivation layer 140. That is, the reflective structure 150 may be apart from the semiconductor light-emitting structure 110 in a normal direction of an outer peripheral surface of the semiconductor light-emitting structure 110 with the passivation layer 140 therebetween. The reflective structure 150 may be formed conformally. The reflective structure 150 may include a distributed Bragg reflector (DBR), and may include a plurality of layers. Respective sidewalls of the first conductive semiconductor layer 112, the active layer 114, and the second conductive semiconductor layer 116 included in the semiconductor light-emitting structure 110 and a sidewall of the transparent electrode layer 130 may be covered by the reflective structure 150. In a plan (X-Y plane in FIG. 1) view, the semiconductor light-emitting structure 110 and the transparent electrode layer 130 may be surrounded by the reflective structure 150. The reflective structure 150 may include a DBR.

The first electrode layer 171 included in the electrode layer may cover a sidewall of the reflective structure 150, and the passivation layer 140, the reflective structure 150, and the first electrode layer 171 may be sequentially stacked. The first electrode layer 171 may be electrically connected to the second conductive semiconductor layer 116.

The first electrode layer 171 may include silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof. However, embodiments of the present disclosure are not limited thereto.

As shown in FIG. 2, the second conductive semiconductor layer 116 may have a surface in contact with the active layer 114 and a surface in contact with the transparent electrode layer 130, wherein, in the second conductive semiconductor layer 116, the surface in contact with the active layer 114 and the surface in contact with the transparent electrode layer 130 may be opposite surfaces in the vertical direction. As such, when the second conductive semiconductor layer 116 is provided between the active layer 114 and the transparent electrode layer 130 and is in contact with each of the active layer 114 and the transparent electrode layer 130, the shortest distance from the first electrode layer 171 to the active layer 114 in the vertical direction may correspond to the thickness of the second conductive semiconductor layer 116 in the vertical direction.

The light-emitting device 100 may have a pillar shape having a central axis extending in a first direction. The light-emitting device 100 may have a width W_100 of less than 100 µm in a second direction (e.g., X direction in FIG. 1) that may be orthogonal to the first direction. In some embodiments, the width W_100 of the light-emitting device 100 may be about 100 nm to about 5 µm, or about 500 nm to about 1,500 nm. When a width W_PITCH_1 of the optical transmission medium 40 is about 50 µm, the width W_100 of the light-emitting device 100 in the horizontal direction may be, for example, 5 µm. Therefore, the width of the optical transmission medium 40 in the horizontal direction may be about ten (10) times the width of the light-emitting device 100 in the horizontal direction.

The transparent electrode layer 130 may have a width that may be substantially similar and/or the same as the width W_100 of the light-emitting device 100 in the second direction (e.g., X direction in FIG. 1). In the first direction, the transparent electrode layer 130 may have a variable thickness. In some embodiments, the maximum thickness of the transparent electrode layer 130 in the first direction may be about 50 nm to about 150 nm.

The transparent electrode layer 130 may include a transparent conductive material. In some embodiments, the transparent electrode layer 130 may include, but not be limited to, at least one of indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), indium tin oxide (In₄Sn₃O₁₂), zinc magnesium oxide (Zn₍₁₋ₓ₎MgₓO, where 0 ≤ x ≤ 1), or a combination thereof. The thickness of the transparent electrode layer 130 in the first horizontal direction may be about 1 nm to about 100 nm (e.g., about 7 nm to about 20 nm). However, embodiments of the present disclosure are not limited thereto.

The first electrode layer 171 may include, but not be limited to, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof. However, embodiments of the present disclosure are not limited thereto.

In a plan (X-Y plane in FIG. 1) view, the semiconductor light-emitting structure 110 may have various planar shapes. For example, the semiconductor light-emitting structure 110 may have a circular, oval, and/or polygonal planar shape. The polygonal planar shape may be a quadrangle, a hexagon, or an octagon. However, embodiments of the present disclosure are not limited thereto. In the plan (X-Y plane in FIG. 1) view, the transparent electrode layer 130 may have a planar shape that may be substantially similar and/or the same as to the planar shape of the semiconductor light-emitting structure 110. The semiconductor light-emitting structure 110 and the transparent electrode layer 130 may form a single pillar shape.

The light-emitting device 100 may include an insulating layer 160 covering the reflective structure 150. In some embodiments, the insulating layer 160 may include, but not be limited to, at least one of an oxide (e.g., silicon oxide (SiO₂)), silicon nitride (Si₃N₄), aluminum (Al), zinc (Zn), zirconium (Zr), hafnium (Hf), gallium (Ga), titanium (Ti), or a combination thereof. For example, the insulating layer 160 may include silicon nitride (Si₃N₄), aluminum oxide (Al₂O₃), zinc oxide (ZnO₂), zirconium oxide (ZrO₂), hafnium oxide (HfO₂), gallium oxide (GaO₂), titanium oxide (TiO₂), or a combination thereof.

The light-emitting device 100 may further include a second electrode layer 172. The second electrode layer 172 may be arranged adjacent to the semiconductor light-emitting structure 110. The first electrode layer 171 and the second electrode layer 172 may not be in physical contact with each other. The second electrode layer 172 may be an electrode of the first conductive semiconductor layer 112. The first electrode layer 171 and the second electrode layer 172 may be electrically connected to the via VIA included in the circuit board.

The second electrode layer 172 may include, but not be limited to, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), or a combination thereof.

The via VIA may be arranged to penetrate the passivation layer 140, the reflective structure 150, and the first electrode layer 171 to a vertical level that may be higher than a lower surface of the transparent electrode layer 130. Therefore, at least a portion of an upper surface of the via VIA may be in physical contact with the transparent electrode layer 130. In addition, at least a portion of the upper surface of the via VIA may be in physical contact with the second electrode layer 172.

According to the light-emitting device 100 described with reference to FIG. 2, by controlling the thickness of the second conductive semiconductor layer 116 according to the wavelength of light emitted from the semiconductor light-emitting structure 110, the active layer 114 may be arranged in the semiconductor light-emitting structure 110 at a position that may optimize the light extraction efficiency of the light-emitting device 100, thereby maximizing the light extraction efficiency of the light-emitting device 100. In addition, the semiconductor light-emitting structure 110 may constitute a micro LED having a width of about 10 µm or less, and the active layer 114 in the semiconductor light-emitting structure 110 may have a multi-quantum well structure so as to be optimized for a fine-sized chip including the micro LED. Therefore, according to the present disclosure, the light-emitting device 100 may be provided to have a structure that may be further optimized for a fine-sized chip.

The optical transmission medium 40 may be attached to a back surface 102B of the first conductive base semiconductor layer 102, which may be opposite to the main surface 102M of the first conductive base semiconductor layer 102. An adhesive 41 may be arranged between the optical transmission medium 40 and the first conductive base semiconductor layer 102. The adhesive 41 may provide adhesive strength to each component so that the optical transmission medium 40 and the first conductive base semiconductor layer 102 may not be physically separated from each other.

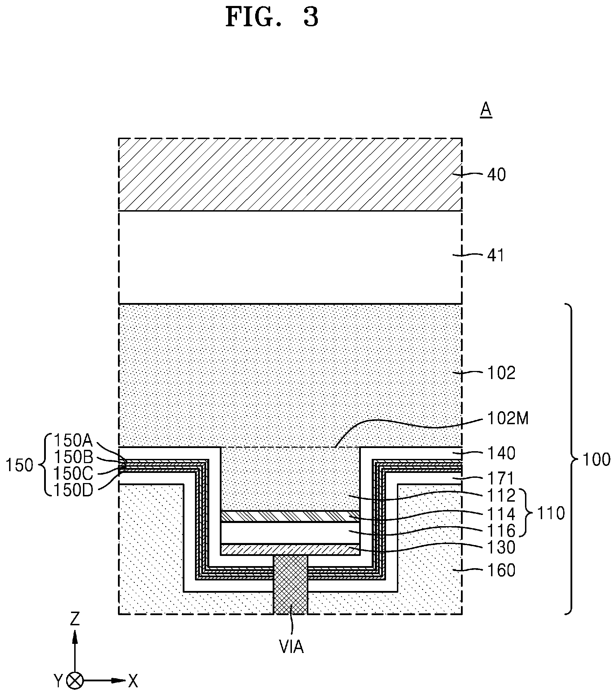

FIG. 3 is an enlarged view of region A in FIG. 2, according to an embodiment.

FIG. 3 may be described together with reference to FIGS. 1 and 2. In FIG. 3, the same reference numerals as those in FIGS. 1 and 2 denote the same members, and thus, repeated descriptions thereof may be omitted for the sake of brevity.

The reflective structure 150 may have a DBR structure in which a first insulating layer 150A, a second insulating layer 150B, a third insulating layer 150C, and a fourth insulating layer 150D may be sequentially stacked. In an embodiment, the first insulating layer 150A and the third insulating layer 150C may include a first insulating material, and the second insulating layer 150B and the fourth insulating layer 150D may include a second insulating material. The first insulating material and the second insulating material may have different refractive indices. In some embodiments, the first insulating material and the second insulating material may include different materials such as, but not limited to, silicon oxide (SiO₂), silicon oxynitride (SiON), titanium oxide (TiO₂), silicon nitride (Si₃N₄), aluminum oxide (Al₂O₃), titanium nitride (TiN), aluminum nitride (AlN), zirconium oxide (ZrO₂), titanium aluminum nitride (TiAlN), titanium silicon nitride (TiSiN), hafnium oxide (HfO₂), niobium oxide (NbO₂), tantalum oxide (TaO₂), magnesium fluoride (MgF₂), or a combination thereof.

The first insulating layer 150A of the reflective structure 150 may be in contact with the passivation layer 140. The first insulating layer 150A may include a material having enhanced total reflection characteristics. In some embodiments, the first insulating layer 150A may include an insulating material having a refractive index that may be less than or equal to the refractive index of the semiconductor light-emitting structure 110 and/or the transparent electrode layer 130. For example, the first insulating layer 150A may include silicon oxide (SiO₂) or magnesium fluoride (MgF₂). However, embodiments of the present disclosure are not limited thereto. The first insulating layer 150A, the second insulating layer 150B, the third insulating layer 150C, and the fourth insulating layer 150D of the reflective structure 150 may each have a thickness of about 10 nm to about 200 nm.

The reflective structure 150 may control light distribution by reflecting light traveling from the inside of the semiconductor light-emitting structure 110 to a sidewall thereof. Because the reflective structure 150 includes a DBR, the reflective structure 150 may act as a band pass filter BPF that suppresses transmission of light of a specific wavelength. Also, a difference in transmittance may occur according to the angle of incidence, and thus, the light distribution may be effectively controlled. In addition, the reflective structure 150 may relatively significantly increase the intensity of light emitted from a specific region by using the difference in transmittance according to the angle of incidence of light emitted from the semiconductor light-emitting structure 110.

Although FIG. 3 shows that the via VIA penetrating the passivation layer 140, the reflective structure 150, and the first electrode layer 171 has a constant width in the horizontal direction, embodiments of the present disclosure may not be limited thereto. For example, the width of the via VIA in the horizontal direction may not be constant. In an embodiment, the via VIA may have a tapered shape in which the width of the via VIA in the horizontal direction increases away from the transparent electrode layer 130.

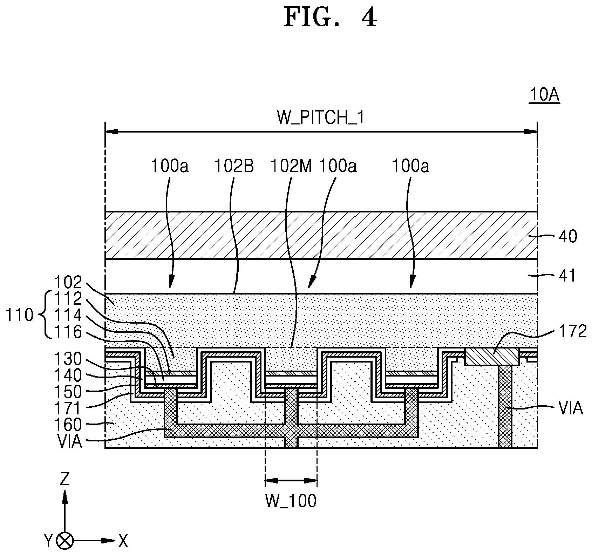

FIG. 4 is a cross-sectional view of a schematic structure of a micro LED array, according to an embodiment.

FIG. 4 may be described together with reference to FIGS. 1 to 3. In FIG. 4, the same reference numerals as those in FIGS. 1 to 3 denote the same members, and thus, redundant descriptions thereof are omitted.

A micro LED array 10A may include a plurality of micro LEDs coupled to one optical transmission medium 40. In FIG. 4, the micro LEDs may also be referred to as light-emitting devices 100a. The light-emitting devices 100a may be arranged apart from each other in the horizontal direction. The plurality of semiconductor light-emitting structures 110 included in the light-emitting devices 100a may be electrically connected to each other through the vias VIA that are integrally formed as a single body. Each light-emitting device 100a may include the semiconductor light-emitting structure 110. The micro LED array 10A may include a plurality of semiconductor light-emitting structures 110 that may be arranged apart from each other in the horizontal direction, and the passivation layer 140, the reflective structure 150, and the first electrode layer 171 that may be stacked to integrally cover the plurality of semiconductor light-emitting structures 110. Therefore, even when the micro LED array 10A includes the light-emitting devices 100a that are arranged apart from each other, layers connecting the light-emitting devices 100a to each other may be integrally formed as a single body rather than apart from each other in the horizontal direction. However, even in such a case, the first electrode layer 171 may not be in physical contact with the second electrode layer 172.

The light-emitting devices 100a may be formed in the same pattern by deposition, and thus may emit light of the same wavelength. In addition, the plurality of light-emitting devices 100a may be connected in parallel with each other. In such a case, even when at least one light-emitting device 100a among the plurality of light-emitting devices 100a does not operate, the remaining light-emitting devices 100a may operate independently of whether or not the at least one light-emitting device 100a operates. Therefore, even when at least one light-emitting device 100a from among the plurality of light-emitting devices 100a does not operate or malfunctions, the micro LED array 10A may normally transmit and/or receive signals by using the light-emitting devices 100a that may operate normally.

In FIG. 4, because the plurality of light-emitting devices 100a are connected to each other through one via VIA, micro LEDs and photodiodes may not be coupled to each other on a one-to-one basis. In an embodiment, in FIG. 4, at least two (2) micro LEDs may be coupled and connected to one photodiode. For example, in FIG. 4, three (3) micro LEDs may be coupled and connected to one photodiode. In FIG. 4, one second electrode layer 172 may correspond to three (3) semiconductor light-emitting structures 110.

In an embodiment, when a plurality of micro LEDs are provided as shown in FIG. 4, the first conductive semiconductor layers 112 respectively included in the semiconductor light-emitting structures 110 may be integrally formed as a single body with the first conductive base semiconductor layer 102. In an embodiment, the reflective structures 150 and the first electrode layers 171 may also be integrally formed as single bodies to cover respective sidewalls of the semiconductor light-emitting structures 110.

In an embodiment, the micro LEDs as the light-emitting devices 100a may be electrically connected to each other through the first conductive semiconductor layer 112 and the first electrode layer 171. In an embodiment, the micro LEDs may not be separated from each other, but may integrally constitute one micro LED array 10A.

In an embodiment, the width W_PITCH_1 of the optical transmission medium 40 may be about 10 µm to about 50 µm. In FIG. 4, when the width W_PITCH_1 of the optical transmission medium 40 is 50 µm, the width W_100 of the light-emitting device 100a in the horizontal direction may be, for example, 5 µm. Therefore, the width of the optical transmission medium 40 in the horizontal direction may be about ten (10) times the width of the light-emitting device 100a in the horizontal direction.

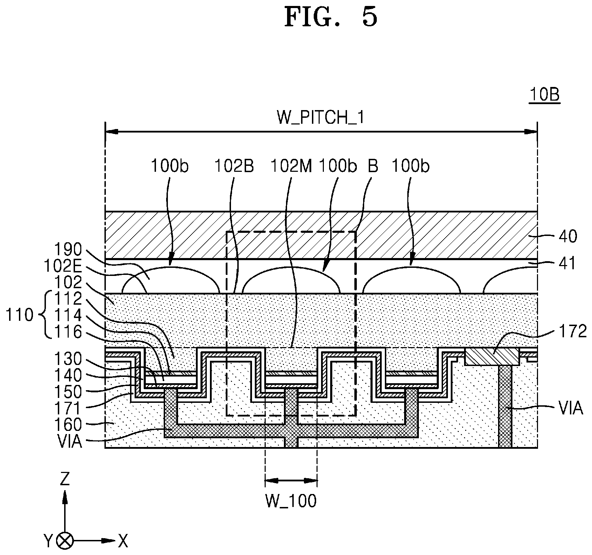

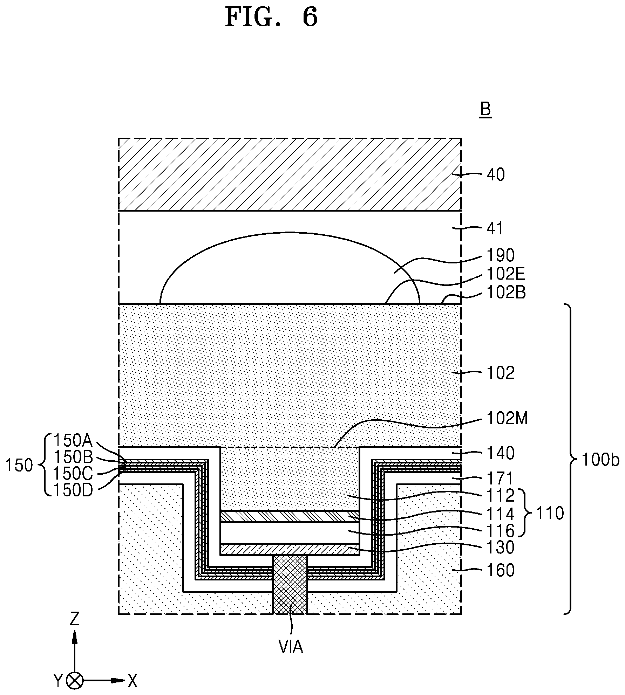

FIG. 5 is a cross-sectional view of a schematic structure of a micro LED array, according to an embodiment. FIG. 6 is an enlarged view of region B in FIG. 5, according to an embodiment.

FIGS. 5 and 6 may be described together with reference to FIGS. 1 to 4. In FIG. 5, the same reference numerals as those in FIGS. 1 to 4 may denote the same members, and thus, redundant descriptions thereof may be omitted for the sake of brevity.

Referring to FIGS. 5 and 6, a micro LED array 10B may include, as a micro LED, a light-emitting device 100b further including a microlens 190.

The microlens 190 may be configured to extract light emitted from the semiconductor light-emitting structure 110. The microlens 190 may be apart from the first conductive semiconductor layer 112 in the vertical direction with the first conductive base semiconductor layer 102 therebetween. The first conductive base semiconductor layer 102 may be in contact with the main surface 102M, which may be in contact with the first conductive semiconductor layer 112, and an emission surface 102E, which may include a portion of the back surface 102B opposite to the main surface 102M. The microlens 190 may be arranged to overlap the semiconductor light-emitting structure 110 in the vertical direction. Because the light-emitting device 100b further includes the microlens 190, the light extraction efficiency of the light-emitting device 100b may be further improved.

The adhesive 41 may be arranged after forming the microlens 190. The adhesive 41 may be formed to a height that completely covers an upper surface of the microlens 190. In an embodiment, the vertical level of the upper surface of the microlens 190 may be lower than the vertical level of an upper surface of the adhesive 41.

In some embodiments, the microlens 190 may include a spherical microlens or an aspherical microlens. In some embodiments, the microlens 190 may include a graded-refractive index layer formed in a multi-layer structure having a gradually decreasing refractive index in the traveling direction of light. The graded-refractive index layer may be formed using an oblique deposition method, sputtering, an evaporation method, or the like. The graded-refractive index layer may be configured to have a gradually decreasing refractive index in the direction of a light emission surface. In some embodiments, the microlens 190 may include, but not be limited to, at least one of titanium oxide (TiO₂), silicon carbide (SiC), gallium nitride (GaN), gallium phosphide (GaP), silicon nitride (Si₃N₄), silicon oxynitride (SiON), zirconium oxide (ZrO₂), indium tin oxide (ITO), aluminum nitride (AlN), aluminum oxide (Al₂O₃), magnesium oxide (MgO), silicon oxide (SiO₂), calcium fluoride (CaF₂), magnesium fluoride (MgF₂), or a combination thereof. However, embodiments of the present disclosure are not limited thereto.

In an embodiment, the width W_PITCH_1 of the optical transmission medium 40 may be about 10 µm to about 50 µm. In FIG. 5, when the width W_PITCH_1 of the optical transmission medium 40 is 50 µm, the width W_100 of the light-emitting device 100b in the horizontal direction may be, for example, 5 µm. Therefore, the width of the optical transmission medium 40 in the horizontal direction may be about ten (10) times the width of the light-emitting device 100b in the horizontal direction.

The micro LED array 10B may also include a plurality of micro LEDs coupled to one optical transmission medium 40, as shown in FIG. 4. The light-emitting devices 100b may be arranged apart from each other in the horizontal direction. As the light-emitting devices 100b are apart from each other in the horizontal direction, the microlenses 190 may also be arranged apart from each other.

The plurality of semiconductor light-emitting structures 110 included in the light-emitting devices 100b may be electrically connected to each other through the vias VIA that may be integrally formed as a single body. Each light-emitting device 100b may include the semiconductor light-emitting structure 110. The micro LED array 10B may include a plurality of semiconductor light-emitting structures 110 that may be arranged apart from each other in the horizontal direction, and the passivation layer 140, the reflective structure 150, and the first electrode layer 171 that may be stacked to integrally cover the plurality of semiconductor light-emitting structures 110. Therefore, even when the micro LED array 10B includes the light-emitting devices 100b that are arranged apart from each other, layers connecting the light-emitting devices 100b to each other may be integrally formed as a single body, rather than apart from each other in the horizontal direction. However, even in such a case, the first electrode layer 171 may not be in physical contact with the second electrode layer 172.

The light-emitting devices 100b may be formed in a substantially similar and/or the same pattern by deposition, and thus may emit light of the same wavelength. In FIG. 5, because the plurality of light-emitting devices 100b are connected to each other through one via VIA, micro LEDs and photodiodes may not be coupled to each other on a one-to-one basis. In an embodiment, in FIG. 5, at least two (2) micro LEDs may be coupled and connected to one photodiode. For example, in FIG. 5, three (3) micro LEDs may be coupled and connected to one photodiode. In FIG. 5, one second electrode layer 172 may correspond to three (3) semiconductor light-emitting structures 110.

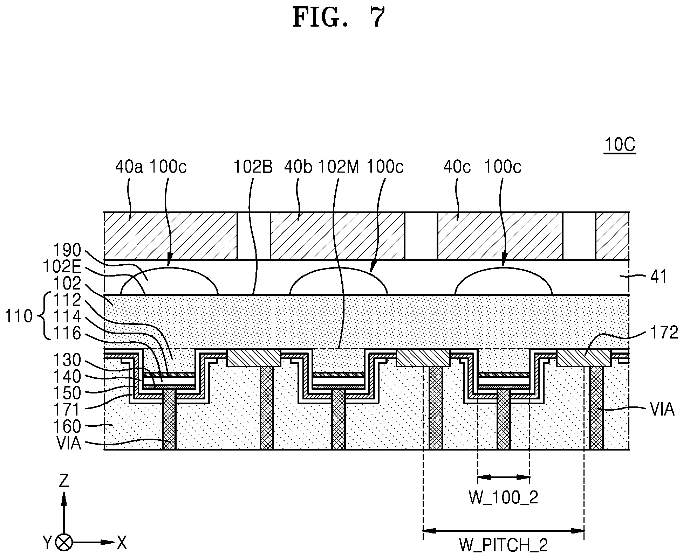

FIG. 7 is a cross-sectional view of a schematic structure of a micro LED array, according to an embodiment.

FIG. 7 may be described together with reference FIGS. 1 to 6. In FIG. 7, the same reference numerals as those in FIGS. 1 to 6 denote the same members, and thus, redundant descriptions thereof may be omitted for the sake of brevity.

Referring to FIG. 7, a micro LED array 10C may include, as a micro LED, a light-emitting device 100c further including the microlens 190.

The light-emitting device 100c may include one semiconductor light-emitting structure 110 and one second electrode layer 172 corresponding thereto. One micro LED as one light-emitting device 100c may be coupled and connected to one optical transmission medium (e.g., a first optical transmission medium 40a, a second optical transmission medium 40b, or a third optical transmission medium 40c) on a one-to-one basis. That is, one light-emitting device 100c may correspond to one first, second, or third optical transmission medium 40a, 40b, or 40c. For example, the first to third optical transmission media 40a to 40c may correspond to respective micro LEDs, and may constitute a plurality of optical transmission media 40a to 40c that may be arranged to be separated from each other. Although the plurality optical transmission media 40a to 40c may be physically separated from each other and arranged apart from each other in the horizontal direction, respective configurations thereof may be the same.

Each of the semiconductor light-emitting structure 110 and the second electrode layer 172 may be in physical contact with the via VIA and receive and/or transmit an electric signal through the via VIA. A micro LED as the light-emitting device 100c may be coupled and connected to a photodiode on a one-to-one basis.

When a width W_PITCH_2 of the first to third optical transmission media 40a to 40c is 10 µm, a width W_100_2 of the light-emitting device 100c in the horizontal direction may be, for example, 5 µm. Therefore, the width of the first to third optical transmission media 40a to 40c in the horizontal direction may be about twice (e.g., two (2) times) the width of the light-emitting device 100c in the horizontal direction.

That is, as shown in FIGS. 2 to 7, the width of the first to third optical transmission media 40a to 40c in the horizontal direction may be formed in a range of about two (2) to about ten (10) times the width of each micro LED in the horizontal direction. The width of the first to third optical transmission media 40a to 40c in the horizontal direction may be greater than two (2), three (3), four (4) or (5) times the width of each micro LED in the horizontal direction. The width of the first to third optical transmission media 40a to 40c in the horizontal direction may be smaller than six (6), seven (7), eight (8), nine (9) or ten (10) times the width of each micro LED in the horizontal direction.

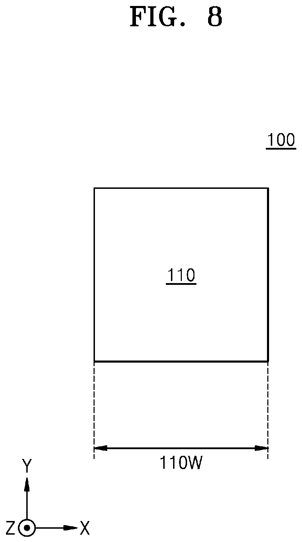

FIGS. 8 to 11 each illustrate a plan view of a schematic planar shape of a semiconductor light-emitting structure, according to an embodiment. FIGS. 8 to 11 may be described together with reference to FIGS. 2 to 7.

Referring to FIG. 8, in a plan (X-Y plane) view, the first conductive semiconductor layer 112, the active layer 114, and the second conductive semiconductor layer 116 included in the semiconductor light-emitting structure 110, and the transparent electrode layer 130 may each have a quadrangular planar shape. In a horizontal direction (e.g., X direction or Y direction) parallel to the main surface 102M of the first conductive base semiconductor layer 102, a width 110W of the semiconductor light-emitting structure 110 may be about 100 µm or less, about 50 µm or less, about 20 µm or less, about 10 µm or less, about 6 µm or less, about 5 µm or less, about 4 µm or less, or about 2 µm or less. However, embodiments of the present disclosure are not limited thereto. In the horizontal direction (e.g., X direction or Y direction) parallel to the main surface 102M of the first conductive base semiconductor layer 102, the transparent electrode layer 130 may have a width that is substantially similar and/or the same as the width 110W of the semiconductor light-emitting structure 110.

A surface of the transparent electrode layer 130 that may be opposite to a surface thereof in contact with the semiconductor light-emitting structure 110 may be in physical contact with an upper surface of the via VIA, as shown in FIGS. 2 to 7.

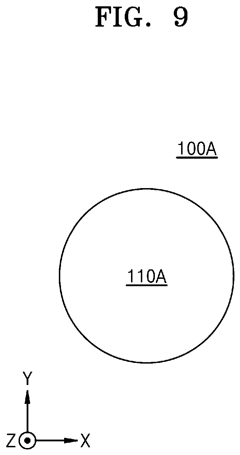

FIG. 9 is a diagram illustrating a light-emitting device 100A, according to an embodiment. In FIG. 9, the same reference numerals as those in FIGS. 2 to 7 denote the same members, and thus redundant descriptions thereof may be omitted for the sake of brevity.

Referring to FIG. 9, the light-emitting device 100A may have a substantially similar and/or the same configuration as described for the light-emitting device 100 with reference to FIG. 2. However, the light-emitting device 100A may include a semiconductor light-emitting structure 110A instead of the semiconductor light-emitting structure 110. In a plan (X-Y plane) view, the first conductive semiconductor layer 112, the active layer 114, and the second conductive semiconductor layer 116 included in the semiconductor light-emitting structure 110A may each have a circular planar shape.

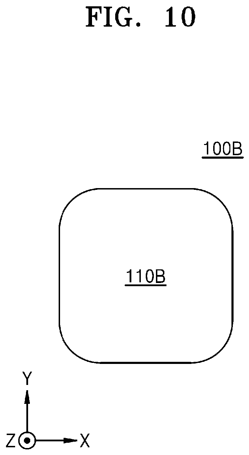

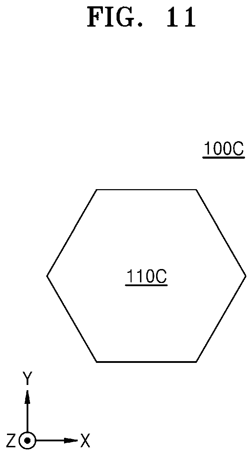

FIGS. 10 and 11 each depict a plan view illustrating a light-emitting device 100B or 100C, according to an embodiment. FIG. 10 is a schematic plan view illustrating an example planar shape of a semiconductor light-emitting structure 110B included in the light-emitting device 100B, and FIG. 11 is a schematic plan view illustrating an example planar shape of a semiconductor light-emitting structure 110C included in the light-emitting device 100C.

Referring to FIG. 10, the light-emitting device 100B may have a substantially similar and/or the same configuration as described for the light-emitting device 100 with reference to FIG. 2. However, the light-emitting device 100B may include the semiconductor light-emitting structure 110B. The semiconductor light-emitting structure 110B may have a substantially similar and/or the same configuration as described for the semiconductor light-emitting structure 110 with reference to FIG. 2. However, in a plan (X-Y plane) view, the semiconductor light-emitting structure 110B may have a quadrangular planar shape with round corners.

Referring to FIG. 11, the light-emitting device 100C may have a substantially similar and/or the same configuration as described for the light-emitting device 100 with reference to FIG. 2. However, the light-emitting device 100C may include the semiconductor light-emitting structure 110C. The semiconductor light-emitting structure 110C may have a substantially similar and/or the same configuration as described for the semiconductor light-emitting structure 110 with reference to FIG. 2. However, in a plan (X-Y plane) view, the semiconductor light-emitting structure 110C may have a hexagonal planar shape.

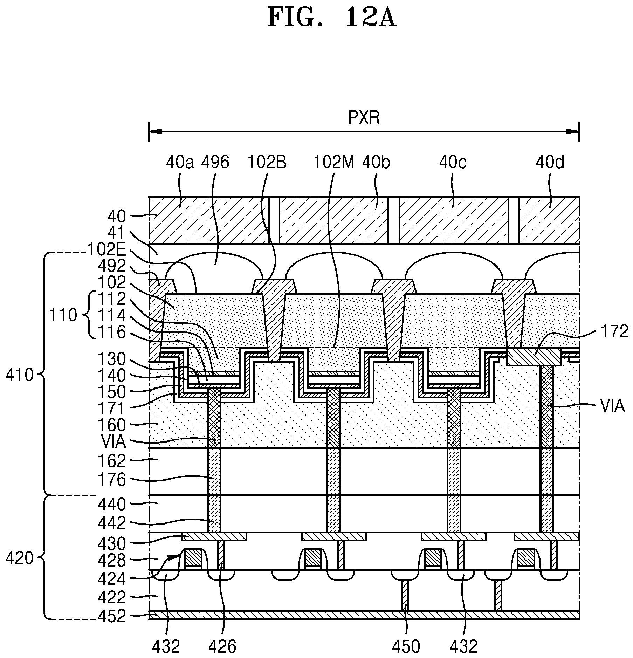

FIG. 12A is a schematic cross-sectional view of a region of an optical interconnect system, according to an embodiment. In FIG. 12A, the same reference numerals as those in FIGS. 1 to 11 denote the same members, and thus, redundant descriptions thereof may be omitted for the sake of brevity.

Referring to FIG. 12A, a pixel region PXR is shown. The pixel region PXR may include a pixel array 410 and a circuit board 420. The circuit board 420 may include driving circuits. The pixel array 410 may include a plurality of pixels arranged in the pixel region PXR on the circuit board 420. Each pixel may correspond to a micro LED array. The circuit board 420 in FIG. 12A and the following drawings may correspond to the circuit board IC in FIG. 1.

The circuit board 420 may be and/or may include a driving circuit board including a plurality of transistors. In some embodiments, the circuit board 420 may include an application-specific integrated circuit (ASIC) having a plurality of driver circuits. In some embodiments, the circuit board 420 may include a flexible substrate. In such a case, the optical interconnect system may be implemented as a variable and/or curved optical interconnect system.

The plurality of pixels may include a plurality of first sub-pixels, a plurality of second sub-pixels, and a plurality of third sub-pixels, each configured to emit light of a particular wavelength (e.g., light of a particular color). The plurality of first sub-pixels, the plurality of second sub-pixels, and the plurality of third sub-pixels may each include a light-emitting device having a substantially similar and/or the same configuration as described for the semiconductor light-emitting structure 110 with reference to FIG. 2.

In some embodiments, the first to third sub-pixels may be configured to emit red (R) light, green (G) light, and blue (B) light, respectively. In some embodiments, each of the plurality of pixels may include first to third sub-pixels arranged in a Bayer pattern. That is, each of the plurality of pixels may include first and third sub-pixels arranged in a first diagonal direction, and two (2) second sub-pixels arranged in a second diagonal direction crossing the first diagonal direction. In some embodiments, some of the plurality of pixels may be configured to emit light of a color other than red (R), green (G), and blue (B), for example, yellow (Y) light. However, embodiments of the present disclosure are not limited thereto.

The circuit board 420 may include a semiconductor substrate 422, a driving circuit including a plurality of driving devices 424 formed on the semiconductor substrate 422 and including transistors, a plurality of interconnectors 426 electrically connected to the plurality of driving devices 424, and a plurality of wiring lines 430 connected to the plurality of interconnectors 426. The plurality of driving devices 424 constituting the driving circuit, the plurality of interconnectors 426, and the plurality of wiring lines 430 may be covered by an insulating layer 428. The circuit board 420 may further include a first bonding insulating layer 440 on the insulating layer 428, and a plurality of first bonding electrodes 442 penetrating the first bonding insulating layer 440 and connected to the plurality of wiring lines 430. One wiring line 430 may be connected to one semiconductor light-emitting structure 110 or one second electrode layer 172.

The semiconductor substrate 422 may include a plurality of impurity regions 432 that may constitute source/drain regions of the plurality of transistors constituting the plurality of driving devices 424. The semiconductor substrate 422 may include a semiconductor, such as, but not limited to, silicon (Si) or germanium (Ge), or a compound semiconductor, such as, but not limited to, silicon germanium (SiGe), silicon carbide (SiC), gallium arsenide (GaAs), indium arsenide (InAs), indium phosphide (InP), or the like. The semiconductor substrate 422 may further include a plurality of through electrodes 450, such as through silicon vias (TSVs), connected to the driving circuit, and a plurality of substrate wiring lines 452 connected to the plurality of through electrodes 450.

The driving circuit may be and/or may include a circuit for controlling driving of the pixel or the first to third sub-pixels. Some of the plurality of impurity regions 432 may be electrically connected to at least one selected from the plurality of first sub-pixels to the plurality of third sub-pixels through the interconnector 426, the wiring line 430, and the first bonding electrode 442. In some embodiments, some of the plurality of impurity regions 432 may be connected to one substrate wiring line 452 from among the plurality of substrate wiring lines 452 through the through electrode 450.

Upper surfaces of the plurality of first bonding electrodes 442 and an upper surface of the first bonding insulating layer 440 may form an upper surface of the circuit board 420. The plurality of first bonding electrodes 442 included in the circuit board 420 may be bonded to a plurality of second bonding electrodes 176 included in the pixel array 410 to provide an electrical connection path. In addition, each second bonding electrode 176 may be electrically connected to the via VIA. In some embodiments, the plurality of first bonding electrodes 442 and the plurality of second bonding electrodes 176 may each include a copper (Cu) film. The plurality of first bonding electrodes 442 and the plurality of second bonding electrodes 176 may each further include a barrier metal layer surrounding the copper (Cu) film. The barrier metal layer may include, but not be limited to, tantalum (Ta), tantalum nitride (TaN), or a combination thereof.

The first bonding insulating layer 440 included in the circuit board 420 may be bonded to a second bonding insulating layer 162 included in the pixel array 410. The first bonding insulating layer 440 and the second bonding insulating layer 162 may each include, but not be limited to, silicon oxide (SiO), silicon nitride (Si₃N₄), silicon carbon nitride (SiCN), silicon oxycarbide (SiOC), silicon oxynitride (SiON), silicon oxycarbonitride (SiOCN), or a combination thereof.

In the pixel array 410, the first to third sub-pixels may each include the semiconductor light-emitting structure 110 as described with reference to FIG. 2. For example, the pixel array 410 may include the first conductive base semiconductor layer 102 having the main surface 102M and the back surface 102B, which may be opposite to each other, and a plurality of semiconductor light-emitting structures 110 arranged on the main surface 102M of the first conductive base semiconductor layer 102. The plurality of semiconductor light-emitting structures 110 may be apart from each other in the horizontal direction parallel to the main surface 102M of the first conductive base semiconductor layer 102. The plurality of semiconductor light-emitting structures 110 may each include the first conductive semiconductor layer 112, the active layer 114, and the second conductive semiconductor layer 116 that may be sequentially stacked in the vertical direction perpendicular to the main surface 102M of the first conductive base semiconductor layer 102. The configurations of the first conductive semiconductor layer 112, the active layer 114, and the second conductive semiconductor layer 116 may be substantially similar and/or the same as described with reference to FIG. 2. First to fourth transmission media 40a to 40d, which may be separated from each other and arranged apart from each other, may also be substantially similar and/or the same as described with reference to FIG. 7.

The pixel array 410 may further include a grid electrode 492 penetrating the first conductive base semiconductor layer 102 in the vertical direction. The grid electrode 492 may include a grid-shaped metal layer. The grid electrode 492 may be in physical contact with the second electrode layer 172. Therefore, the grid electrode 492 and the second electrode layer 172 may function as the same electrode. Herein, the grid electrode 492 may also be referred to as a first electrode that may be the same as the second electrode layer 172. The grid electrode 492 may include local regions extending along regions between each pair of the plurality of semiconductor light-emitting structures 110 in a plan view parallel to the main surface 102M of the first conductive base semiconductor layer 102, wherein the local regions of the grid electrode 492 may be connected to each other to form a single layer, and may be arranged to surround each of the plurality of semiconductor light-emitting structures 110. The local regions of the grid electrode 492 may be connected to each other to form a grid shape or a mesh shape. As such, by arranging the grid electrode 492 to fill spaces between each pair of the plurality of semiconductor light-emitting structures 110, current spreading may be improved, thereby improving the light emission efficiency in the pixel array 410 of the optical interconnect system. In some embodiments, the grid electrode 492 may be formed through a plating process to have a structure that stably fills relatively narrow spaces between each pair of the plurality of semiconductor light-emitting structures 110.

A portion of the grid electrode 492 may be in contact with a sidewall of the first conductive base semiconductor layer 102. Another portion of the grid electrode 492 may be in contact with the back surface 102B of the first conductive base semiconductor layer 102 to define the emission surface 102E including a portion of the back surface 102B of the first conductive base semiconductor layer 102. In some embodiments, the grid electrode 492 may include, but not be limited to, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), or a combination thereof.

A plurality of microlenses 496 may be arranged on the emission surface 102E defined by the grid electrode 492 in the back surface 102B of the first conductive base semiconductor layer 102. The plurality of microlenses 496 may each be in contact with a portion of the grid electrode 492 that covers the back surface 102B. The plurality of microlenses 496 may be arranged to overlap the plurality of semiconductor light-emitting structures 110 in a direction perpendicular to the main surface 102M of the first conductive base semiconductor layer 102. The configuration of the plurality of microlenses 496 may be substantially similar and/or the same as that described for the microlens 190 with reference to FIG. 5.

The plurality of semiconductor light-emitting structures 110 included in the pixel array 410 of the optical interconnect system 1 may be configured to emit light of a wavelength λ having a range of about 400 nm to about 700 nm, for example, a wavelength λ having a range of 490 nm to 700 nm. The shortest distance from the transparent electrode layer 130 to the active layer 114 in the direction perpendicular to the main surface 102M of the first conductive base semiconductor layer 102 may be determined according to the wavelength λ of the light emitted from the semiconductor light-emitting structure 110.

A surface of the second bonding insulating layer 162 that faces the circuit board 420 and surfaces of the plurality of second bonding electrodes 176 that face the circuit board 420 may extend in one plane. The second bonding insulating layer 162 may form dielectric-dielectric bonding with the first bonding insulating layer 440. The circuit board 420 and the pixel array 410 may be bonded to each other by bonding between the plurality of first bonding electrodes 442 and the plurality of second bonding electrodes 176 and bonding between the first bonding insulating layer 440 and the second bonding insulating layer 162.

In some embodiments, the bonding between the plurality of first bonding electrodes 442 and the plurality of second bonding electrodes 176 may be, for example, copper (Cu)-copper (Cu) bonding, and the bonding between the first bonding insulating layer 440 and the second bonding insulating layer 162 may be, for example, dielectric-dielectric bonding, such as silicon carbon nitride-silicon carbon nitride (SiCN-SiCN) bonding. The circuit board 420 and the pixel array 410 may be bonded to each other by hybrid bonding including copper (Cu)-copper (Cu) bonding and dielectric-dielectric bonding, and may be bonded to each other without a separate adhesive layer.

The optical interconnect system 1, according to an embodiment, may include a plurality of semiconductor light-emitting structures 110, and by controlling the thickness of the second conductive semiconductor layer 116 according to the wavelength of light emitted from the plurality of semiconductor light-emitting structures 110, the active layer 114 in each of the plurality of semiconductor light-emitting structures 110 may be arranged at a position that may optimize the light extraction efficiency of the light-emitting device. Therefore, the light extraction efficiency in the pixel region PXR of the optical interconnect system 1 may be maximized. In addition, in the pixel region PXR of the optical interconnect system 1, the semiconductor light-emitting structure 110 may constitute a micro LED having a width of about 10 µm or less, and the active layer 114 in the semiconductor light-emitting structure 110 may have a multi-quantum well structure so as to be optimized for a fine-sized chip including the micro LED. Therefore, the optical interconnect system 1 may be provided to have a structure that may be further optimized for a fine-sized chip, when compared to related optical interconnect systems.

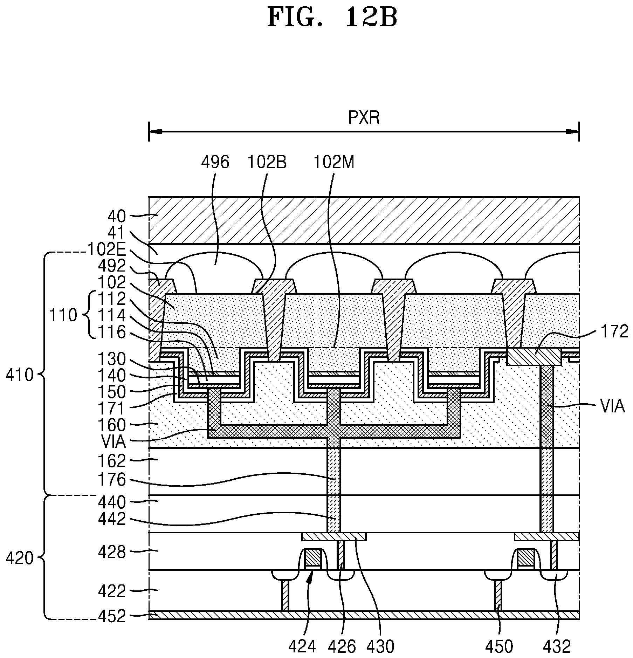

FIG. 12B is a schematic cross-sectional view of a region of an optical interconnect system, according to an embodiment.

FIG. 12B may be described together with reference to FIG. 12A, and the differences from FIG. 12A may be mainly described. Referring to FIG. 12B, the via VIA may be connected to each semiconductor light-emitting structure 110, and a plurality of vias VIA may be connected to each other at one point to form a trident shape. The vias VIA connected to each other may be bonded to one second bonding electrode 176. In addition, one via VIA may be connected to the second electrode layer 172, and the one via VIA connected to the second electrode layer 172 may be bonded to one second bonding electrode 176.

Each second bonding electrode 176 electrically connected to the semiconductor light-emitting structure 110 and the second electrode layer 172 may be bonded to the first bonding electrode 442. In FIG. 12A, the wiring lines 430, the interconnectors 426, and the driving devices 424 electrically connected to three (3) semiconductor light-emitting structures 110 have a one-to-one correspondence with each other. However, as shown in FIG. 12B, a plurality of semiconductor light-emitting structures 110 may be connected to one wiring line 430, one interconnector 426, and one driving device 424. In FIG. 12B, at least two (2) micro LEDs may be coupled and connected to the optical transmission medium 40. For example, in FIG. 12B, three (3) micro LEDs may be coupled and connected to the optical transmission medium 40. In addition, at least two (2) micro LEDs may be coupled and connected to a photodiode. For example, in FIG. 12B, three (3) micro LEDs may be coupled and connected to a photodiode.

FIGS. 13 to 25 are cross-sectional views illustrating a process sequence of a method of manufacturing an optical interconnect system including a micro LED array, according to an embodiment. An example method of manufacturing of the optical interconnect system illustrated in FIG. 12A may be described with reference to FIGS. 13 to 25.

Referring to FIG. 13, by using a semiconductor single crystal growth process, a deposition process, an etching process, or the like that uses a growth substrate 401, a structure, in which a first conductive base semiconductor layer 102, a plurality of semiconductor light-emitting structures 110 arranged in a pixel region PXR and each including a first conductive semiconductor layer 112, an active layer 114, and a second conductive semiconductor layer 116, and a plurality of transparent electrode layers 130 covering the plurality of semiconductor light-emitting structures 110 are arranged, may be formed on the growth substrate 401.

The growth substrate 401 may be a substrate for semiconductor single crystal growth, and may include, but not be limited to, at least one of aluminum nitride (AlN), aluminum gallium nitride (AlGaN), zinc oxide (ZnO₂), gallium arsenide (GaAs), magnesium aluminate (MgAl₂O₄), magnesium oxide (MgO), lithium aluminate (LiAlO₂), lithium gallium oxide (LiGaO₂), gallium nitride (GaN), or a combination thereof. In some embodiments, in order to improve the crystallinity and light extraction efficiency of the semiconductor layers, at least a portion of an upper surface of the growth substrate 401 may have an uneven structure. In this case, irregularities may also be formed in the layers grown on the uneven portion of the upper surface of the growth substrate 401.

In some embodiments, in order to form the structure illustrated in FIG. 13, after sequentially forming the first conductive base semiconductor layer 102, the first conductive semiconductor layer 112, the active layer 114, and the second conductive semiconductor layer 116 on the growth substrate 401, and forming the transparent electrode layer 130 on the second conductive semiconductor layer 116, a portion of each of the transparent electrode layer 130, the second conductive semiconductor layer 116, the active layer 114, and the first conductive semiconductor layer 112 may be etched through an etching process using a hard mask pattern as an etch mask, so that the plurality of semiconductor light-emitting structures 110, which are apart from each other on the first conductive base semiconductor layer 102, and the plurality of transparent electrode layers 130 covering the plurality of semiconductor light-emitting structures 110 remain. The plurality of semiconductor light-emitting structures 110, together with the plurality of transparent electrode layers 130, may form a plurality of pillar shapes having a circular, oval, or polygonal planar shape.

The first conductive base semiconductor layer 102, the first conductive semiconductor layer 112, the active layer 114, and the second conductive semiconductor layer 116 may be formed using a metal organic chemical vapor deposition (MOCVD), hydride vapor phase epitaxy (HVPE), or molecular beam epitaxy (MBE) process. The constituent material and thickness of each of the first conductive base semiconductor layer 102, the first conductive semiconductor layer 112, the active layer 114, and the second conductive semiconductor layer 116 may be substantially similar and/or the same as described with reference to FIG. 2.

In some embodiments, a wet etching process may be further performed to remove regions damaged by the etching in each of the plurality of semiconductor light-emitting structures 110. In the wet etching process, by controlling process conditions such that selectivity differs between crystal planes, only the damaged regions in each of the plurality of semiconductor light-emitting structures 110 may be selectively removed, and a sidewall of each of the plurality of semiconductor light-emitting structures 110 may have a profile that extends in the vertical direction with respect to the main surface 102M of the first conductive base semiconductor layer 102. Also, non-radiative recombination due to the damaged regions in the sidewall of each of the plurality of semiconductor light-emitting structures 110 may be reduced, and thus, the luminance of a light-emitting device to be formed may be improved, when compared to related optical interconnect systems.

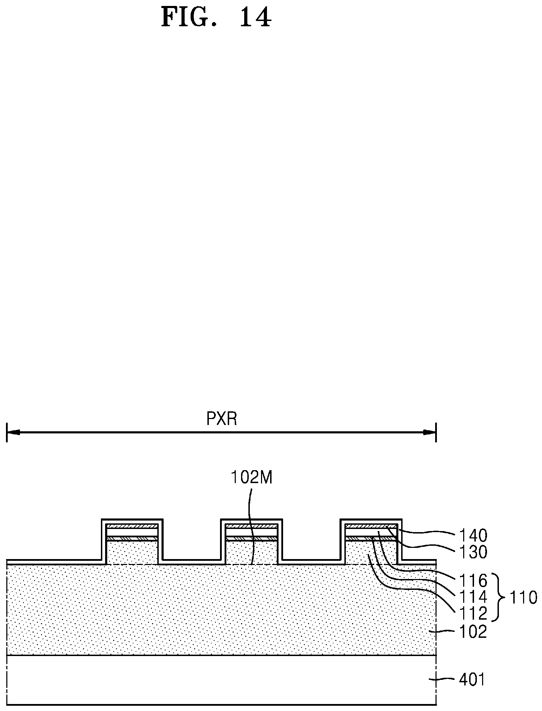

Referring to FIGS. 14 to 16, a passivation layer 140, a reflective structure 150, and a first electrode layer 171 may be sequentially and conformally formed in the vertical direction to cover an outer wall of the semiconductor light-emitting structure 110. Although the passivation layer 140, the reflective structure 150, and the first electrode layer 171 are shown to have the same thickness, the thicknesses of the passivation layer 140, the reflective structure 150, and the first electrode layer 171 are not limited to the drawings, and may be different from each other.

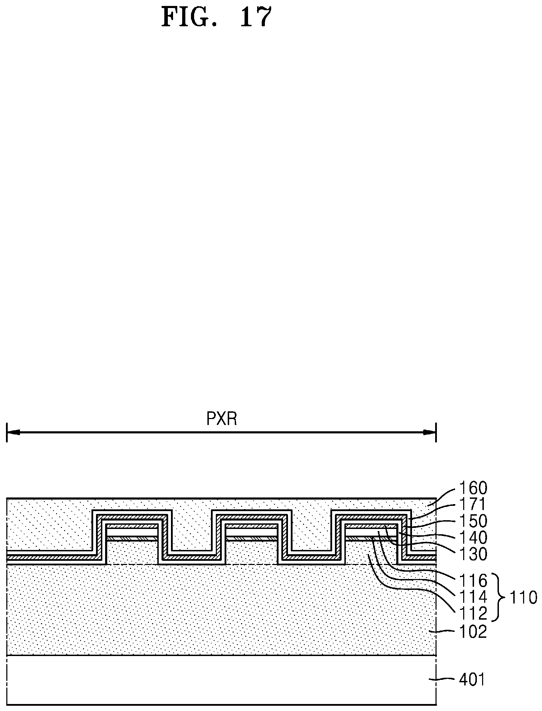

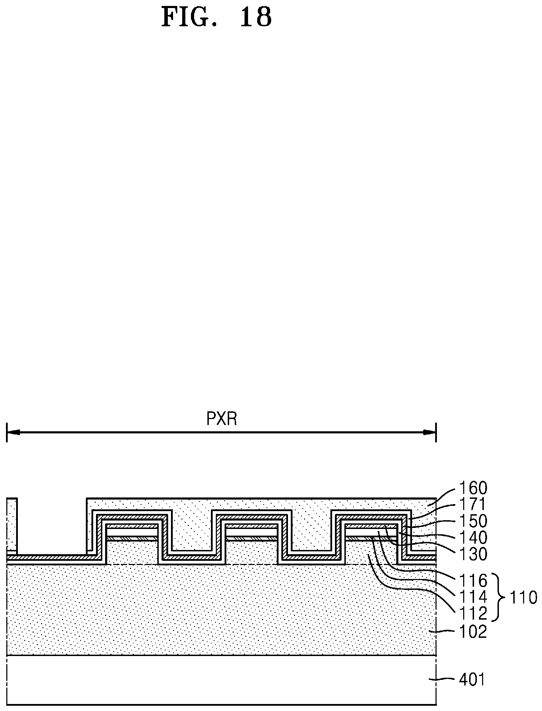

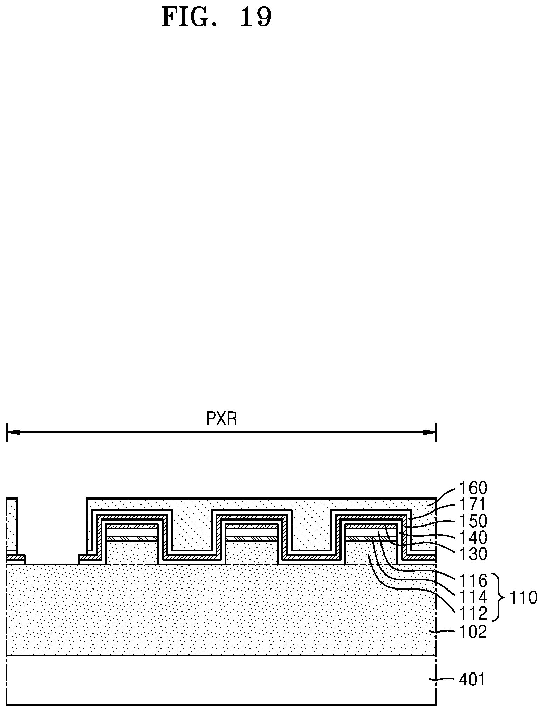

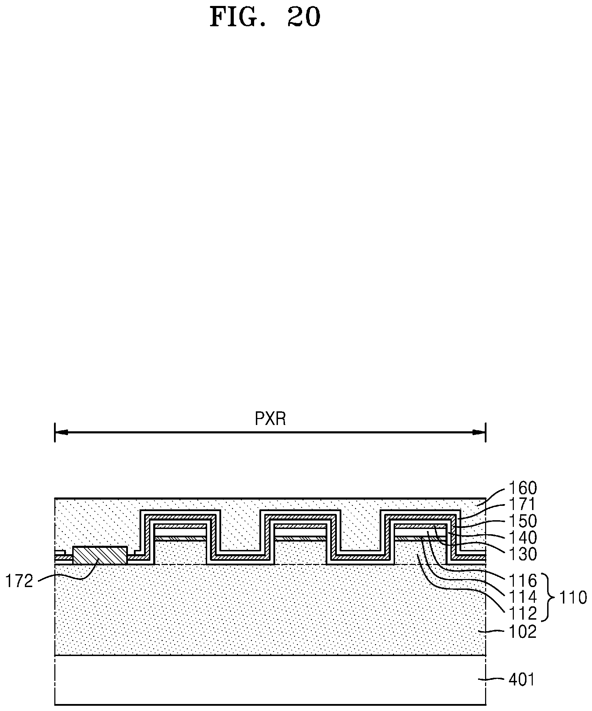

Referring to FIG. 17, an insulating layer 160 may be formed to cover an outer wall of the first electrode layer 171. The insulating layer 160 may be formed to have a constant upper surface height. Referring to FIG. 18, at least a portion of a region of the first electrode layer 171 may be etched back. The width in the horizontal direction of a region where the first electrode layer 171 is etched back may correspond to the width in the horizontal direction of a region where the insulating layer 160 is etched back. Referring to FIG. 19, the reflective structure 150 and the passivation layer 140 may be etched back. The width in the horizontal direction of a region where the reflective structure 150 and the passivation layer 140 are etched back may be less than the width in the horizontal direction of the region where the first electrode layer 171 is etched back. Referring to FIG. 20, a second electrode layer 172 may be formed in the region where the reflective structure 150 and the passivation layer 140 have been etched back. The second electrode layer 172 may not be in physical contact with the first electrode layer 171. After the second electrode layer 172 is formed, an insulating layer 160 may be formed on the etched-back region in FIGS. 18 and 20. Therefore, the insulating layer 160 may cover an upper surface of the second electrode layer 172.

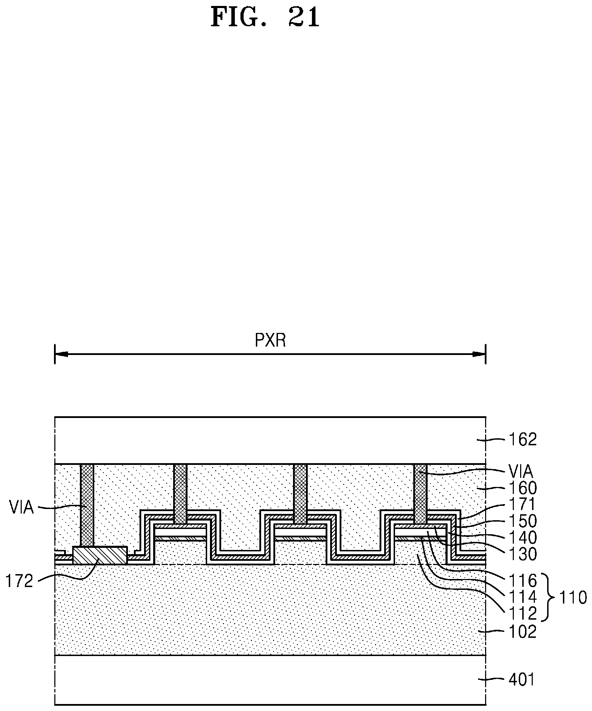

Referring to FIG. 21, a via VIA electrically connected to the semiconductor light-emitting structure 110 and the second electrode layer 172 in the pixel region PXR may be formed in the result of FIG. 20. In an embodiment, before forming the via VIA, some portions of each region where the via VIA is to be formed may be etched. When etching the semiconductor light-emitting structure 110, a portion of an upper surface of each of the plurality of transparent electrode layers 130 may be exposed. Thereafter, the via VIA may be formed to cover the exposed upper surface of the transparent electrode layer 130.

Referring to FIG. 21, a second bonding insulating layer 162 may be formed to cover the plurality of vias VIA and the insulating layer 160 in the pixel region PXR. The second bonding insulating layer 162 may be formed to have a flat upper surface.

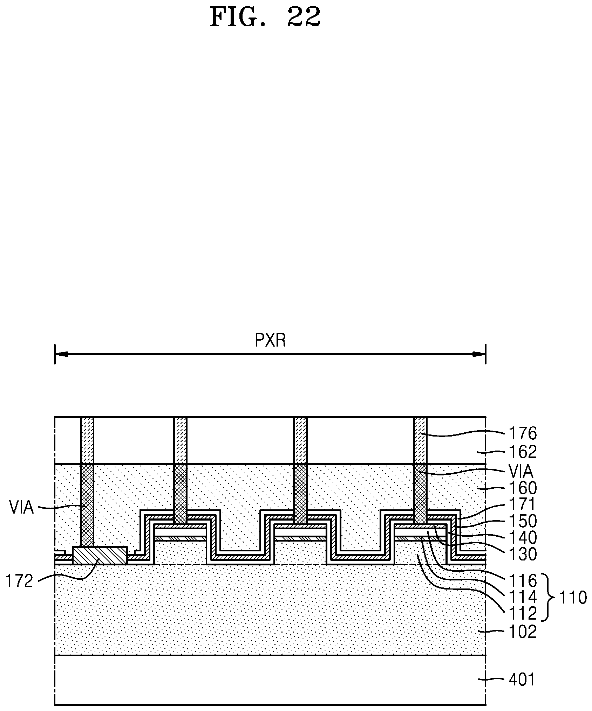

Referring to FIG. 22, in the pixel region PXR, some regions of the second bonding insulating layer 162 may be etched to form a plurality of via holes exposing the plurality of vias VIA, and then, a plurality of second bonding electrodes 176 may be formed to fill the plurality of via holes.

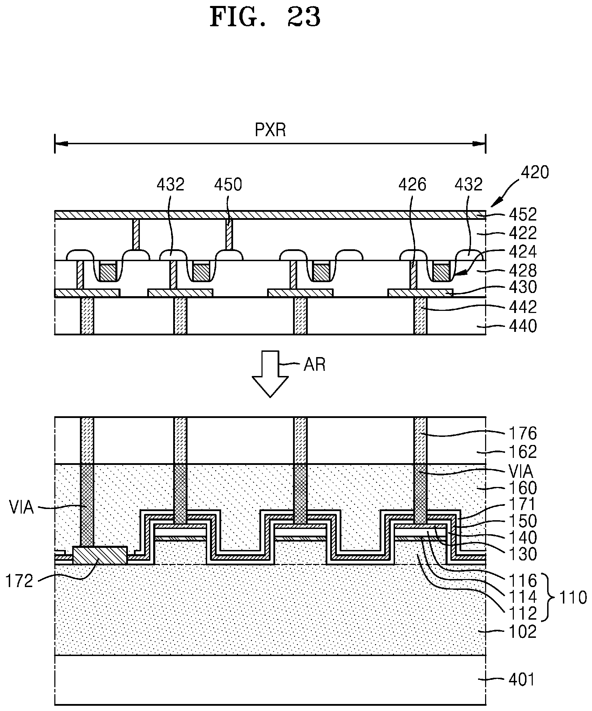

Referring to FIG. 23, after the circuit board 420 is prepared, the circuit board 420 may be positioned above the result of FIG. 22 such that the second bonding insulating layer 162 and the plurality of second bonding electrodes 176 in the result of FIG. 22 face the first bonding insulating layer 440 and the plurality of first bonding electrodes 442 included in the circuit board 420, respectively, and the circuit board 420 may be pressed in the direction indicated by an arrow AR on the surface where the second bonding insulating layer 162 and the plurality of second bonding electrodes 176 are exposed, to achieve bonding between the plurality of first bonding electrodes 442 and the plurality of second bonding electrodes 176 and bonding between the first bonding insulating layer 440 and the second bonding insulating layer 162.

The bonding between the plurality of first bonding electrodes 442 and the plurality of second bonding electrodes 176 and the bonding between the first bonding insulating layer 440 and the second bonding insulating layer 162 may be achieved by wafer bonding, for example, the hybrid bonding described above.

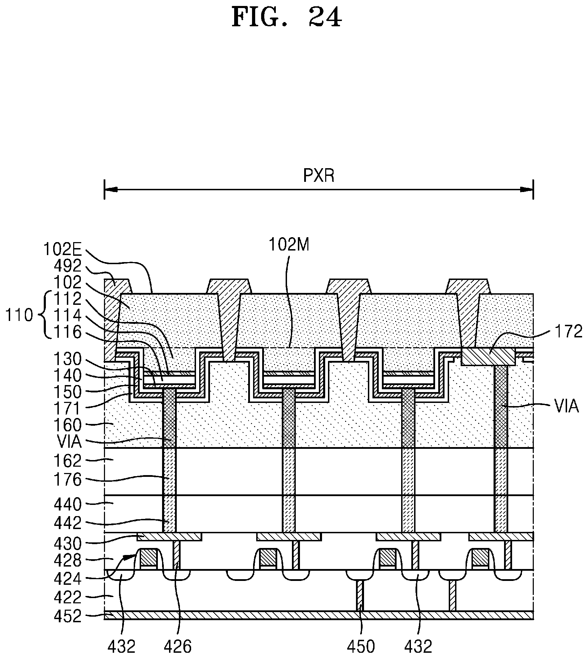

Referring to FIG. 24, in the result in which the bonding between the plurality of first bonding electrodes 442 and the plurality of second bonding electrodes 176 and the bonding between the first bonding insulating layer 440 and the second bonding insulating layer 162 have been achieved according to the process described with reference to FIG. 23, the growth substrate 401 covering the first conductive base semiconductor layer 102 may be removed to expose the first conductive base semiconductor layer 102. The growth substrate 401 may be removed by various processes, such as, but not limited to, laser lift-off, mechanical polishing or mechanical chemical polishing, and an etching process. After the growth substrate 401 is removed to expose the first conductive base semiconductor layer 102, the thickness of the first conductive base semiconductor layer 102 may be reduced using a polishing process, such as, but not limited to, a chemical mechanical polishing (CMP) process.

Thereafter, in the pixel region PXR, some regions of the first conductive base semiconductor layer 102 and some regions of the reflective structure 150 may be etched to provide a grid-shaped or mesh-shaped electrode space penetrating the first conductive base semiconductor layer 102 and the reflective structure 150, and a conductive material may be filled in the electrode space to form a grid electrode 492. In the pixel region PXR, the grid electrodes 492 may be formed to be connected to each other in a grid shape or a mesh shape.

The grid electrode 492 may be formed to include a portion covering the back surface 102B of the first conductive base semiconductor layer 102 in the pixel region PXR. The grid electrode 492 may be formed using a plating process. However, embodiments of the present disclosure are not limited thereto.

Thereafter, as illustrated in FIG. 25, a plurality of microlenses 496 may be formed to cover a plurality of emission surfaces 102E each defined by the grid electrode 492 in the back surface 102B of the first conductive base semiconductor layer 102. Thereafter, as shown in FIG. 5, after forming an adhesive (41 in FIG. 5) covering an upper surface of the microlens 190, an optical transmission medium 40 may be attached thereto, to thereby form an optical interconnect system.

Hereinbefore, an example method of manufacturing the optical interconnect system described with reference to FIG. 12A has been described with reference to FIGS. 13 to 25. However, one of ordinary skill in the art may understand that various modifications and changes may be made to the method described with reference to FIGS. 13 to 25 within the scope of the present disclosure, to thereby manufacture the micro LED arrays 10, 10A, 10B, and 10C described with reference to FIGS. 2 to 7.

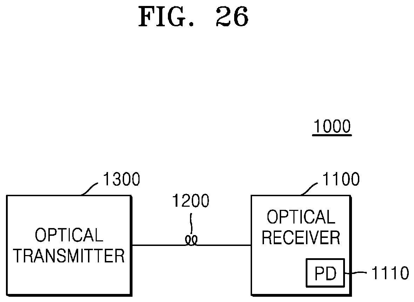

FIG. 26 is a block diagram of an optical interconnect system including a photodiode, according to an embodiment.

Referring to FIG. 26, an optical communication system 1000 may include an optical receiver 1100, a channel 1200, and an optical transmitter 1300. The optical transmitter 1300 may convert an electrical signal into an optical signal and transmit the converted optical signal to the optical receiver 1100 through the channel 1200, and the optical receiver 1100 may convert the input optical signal back into an electrical signal.

A photodiode 1110 included in the optical receiver 1100 may correspond to the photodiode 20 described with reference to FIG. 1. That is, the photodiode 1110 may convert an optical signal received by the optical receiver 1100 into an electrical signal and transmit the converted electrical signal to a substrate. The photodiode 1110 may include a light-absorbing layer that absorbs light, and an electrode that transmits an electric signal generated by the light in the light-absorbing layer.

The channel 1200 may be a path through which an optical signal passes, and may be implemented using an optical fiber. The channel 1200 of FIG. 28 may correspond to the optical transmission medium 40 described with reference to FIG. 1.

## Claims

1. An optical interconnect system (1) comprising:
a micro light-emitting diode, LED, array (10) comprising at least one micro LED (100);
a photodiode array (20) adjacent to the micro LED array (10) or on a side of the micro LED array (10) and comprising at least one photodiode;
an optical transmission medium (40) coupled with the micro LED array (10) and the photodiode array (20); and
a circuit board (IC) apart from the optical transmission medium (40) in a vertical direction (Z) with the micro LED array (10) and the photodiode array (20) therebetween,
wherein the at least one micro LED (100) comprises a plurality of layers sequentially stacked in the vertical direction (Z).

2. The optical interconnect system (1) of claim 1, wherein the at least one photodiode is coupled with the at least one micro LED (100) on a one-to-one basis.

3. The optical interconnect system (1) of claim 1 or 2, wherein the optical transmission medium (40) is coupled with the at least one micro LED (100) on a one-to-one basis.

4. The optical interconnect system (1) of any one of claims 1 to 3, wherein at least two micro LEDs (100) of the at least one micro LED (100) are coupled with the optical transmission medium (40).

5. The optical interconnect system (1) of any one of claims 1 to 4, wherein a width (W_PITCH_1) of the optical transmission medium (40) in a horizontal direction (X) is at least or in a range of two to ten times a width (W_100) of each of the at least one micro LED (100) in the horizontal direction (X).

6. The optical interconnect system (1) of any one of claims 1 to 5, wherein the at least one micro LED (100) further comprises:
a semiconductor light-emitting structure (110) comprising first conductive semiconductor layers (112), an active layer (114), and a second conductive semiconductor layer (116) that are sequentially stacked in the vertical direction (Z); and
an electrode layer at least partially covering the second conductive semiconductor layer (116) and apart from the active layer (114) in the vertical direction (Z) with the second conductive semiconductor layer (116) therebetween.

7. The optical interconnect system (1) of claim 6, wherein the at least one micro LED (100) further comprises a reflective structure (150) at least partially covering a sidewall of the semiconductor light-emitting structure (110), and
wherein the reflective structure (150) comprises a distributed Bragg reflector, DBR.

8. The optical interconnect system (1) of claim 7, wherein the electrode layer comprises:
a transparent electrode layer (130) in contact with the second conductive semiconductor layer (116); and
a first electrode layer (171) at least partially covering a sidewall of the reflective structure (150), and
wherein the reflective structure (150) and the first electrode layer (171) are sequentially stacked.

9. The optical interconnect system (1) of claim 8, wherein, based on the at least one micro LED (100) comprising a plurality of micro LEDs (100):
the first conductive semiconductor layers (112) are integrally formed as a single body; and
the reflective structure (150) and the first electrode layer (171) are integrally formed as single bodies to at least partially cover respective sidewalls of the semiconductor light-emitting structure (110), and
wherein the plurality of micro LEDs (100) are coupled with each other through the first conductive semiconductor layers (112) and the first electrode layer (171) to form the micro LED array (10).

10. The optical interconnect system (1) of claim 8 or 9, wherein the at least one micro LED (100) further comprises a second electrode layer (172) adjacent to the semiconductor light-emitting structure (110),
wherein the first electrode layer (171) and the second electrode layer (172) are each bonded to a via (VIA) comprised in the circuit board (IC) through a hybrid bonding process.

11. The optical interconnect system (1) of any one of claims 1 to 10, wherein:
the at least one micro LED (100) comprises a plurality of micro LEDs (100);
the at least one photodiode comprises a plurality of photodiodes;
the optical transmission medium (40) comprises an optical fiber,
wherein each of the plurality of micro LEDs (100) comprises a plurality of layers sequentially stacked in the vertical direction (Z),
wherein the plurality of layers comprises:
a conductive base semiconductor layer (102);
a semiconductor light-emitting structure (110) comprising first conductive semiconductor layers (112), an active layer (114), and a second conductive semiconductor layer (116) that are sequentially stacked on a main surface (102M) of the conductive base semiconductor layer (102) in the vertical direction (Z) perpendicular to the main surface (102M) of the conductive base semiconductor layer (102);
an electrode layer at least partially covering the second conductive semiconductor layer (116) and apart from the active layer (114) in the vertical direction (Z) with the second conductive semiconductor layer (116) therebetween; and
a passivation layer (140) at least partially covering a sidewall of each of the first conductive semiconductor layers (112), the active layer (114), and the second conductive semiconductor layer (116) comprised in the semiconductor light-emitting structure (110).

12. The optical interconnect system (1) of claim 11, wherein the plurality of photodiodes are coupled with the plurality of micro LEDs (100) on a one-to-one basis.

13. The optical interconnect system (1) of claim 11 or 12, wherein at least two micro LEDs (100) of the plurality of micro LEDs (100) are coupled with each of the plurality of photodiodes.

14. The optical interconnect system (1) of any one of claims 11 to 13, wherein at least one micro LED (100) of the plurality of micro LEDs (100) is coupled with the optical transmission medium (40).

15. The optical interconnect system (1) of claim 14, wherein a width (W_PITCH_1) of the optical transmission medium (40) in a horizontal direction (X) is at least or in a range of two to ten times a width (W_100) of each of the at least one micro LED (100) in the horizontal direction (X).
